# EUROPÄISCHE PATENTANMELDUNG

(11) **EP 3 772 480 A1**
(43) Veröffentlichungstag der Anmeldung: **10.02.2021**
(21) Anmeldenummer: 19190918.3
(22) Anmeldetag: 09.08.2019
(51) Int. Cl.: B66B 5/00, G05B 17/00, G01R 31/28

(54) **VERFAHREN ZUM TESTEN PHYSISCHER KOMPONENTEN EINER PERSONENTRANSPORTANLAGE**

(71) Anmelder: Inventio AG, 6052 Hergiswil (CH)
(72) Erfinder: CORTONA, Elena, 8002 Zürich (CH)

(57) **Zusammenfassung**

Die Erfindung betrifft ein Verfahren 199 zum Testen physischer Komponenten 5 einer Personentransportanlage 1. Die zu testende, physische Komponente 5 wird über eine physische Schnittstelle 17 mit einer programmierbaren Vorrichtung 19 wirkverbunden und auf die programmierbare Vorrichtung 19 wird ein dreidimensionaler Digitaler-Doppelgänger-Datensatz 101 als Simulationsumgebung 33 geladen, der eine ausgewählte Personentransportanlage 1 abbildet und simuliert.

## Beschreibung

Die Erfindung betrifft ein Verfahren zum Testen physischer Komponenten einer Personentransportanlage, wobei die zu testende, physische Komponente über eine physische Schnittstelle mit einer programmierbaren Vorrichtung wirkverbunden werden kann.

Personentransportanlagen dienen dazu, Personen innerhalb von Gebäuden oder Bauwerken zu befördern. Eine solche Personentransportanlage kann als Aufzugsanlage, Fahrtreppe oder Fahrsteig konzipiert sein. Je besser die einzelnen, physischen Komponenten einer Personentransportanlage aufeinander abgestimmt sind, desto besser ist deren Zuverlässigkeit, Verfügbarkeit und deren Fahrkomfort. Unter physischen Komponenten sind hierbei alle, bei einer real existierenden Personentransportanlage eingesetzten Komponenten zu verstehen. Diese Komponenten können mechanische Bauteile und Bauteilgruppen, elektrische und elektronische Bauteile und sogar Kombinationen von elektronischen Bauteilen mit dazugehörender Software sein, wie dies beispielsweise bei einer Steuerung der Personentransportanlage der Fall ist.

Logischerweise wird bereits in der Konzeptionsphase und Konstruktionsphase versucht, die Komponenten möglichst optimal auf ihren Einsatzbereich auszulegen. Das Problem, welches sich hier aber immer wieder stellt ist, dass die Wechselwirkungen des Gesamtsystems auf die einzelnen Komponenten aufgrund der systeminhärenten Komplexität nur ungenügend bekannt sind und somit meist auf Annahmen und auf denen zugrunde liegenden Berechnungen beruhen.

Ein weiteres Problem stellt die unermessliche Variantenvielfalt solcher Personentransportanlagen dar. Auch wenn die Hersteller mittels Produktelinien versuchen, diese Variantenvielfalt zu strukturieren, ist doch jede Personentransportanlage aufgrund der kundenspezifischen Auslegung genau auf ihren Einsatzort abgestimmt und damit genaugenommen ein Einzelstück. Das bedeutet beispielsweise für eine Steuerung einer als Aufzugsanlage ausgestalteten Personentransportanlage, dass ein Parametersatz mit sehr präzisen, auf die konfigurationsbedingten Eigenheiten der Aufzugsanlage abgestimmten Steuerungsdaten erforderlich ist. Nur so kann die Aufzugskabine der Aufzugsanlage die richtigen Positionen genau anfahren und durch die richtige Auslegung der Beschleunigungs- und Verzögerungsprofile einen hohen Fahrkomfort für deren Benutzer bieten.

Die Aufteilung in Produktelinien bedeutet aber nicht, dass alle physischen Komponenten von Produktelinie zu Produktelinie unterschiedlich sind. Obwohl sich die Produktelinien in ihrem Aufbau deutlich unterscheiden, können sie gegebenenfalls gleichartige physische Komponenten wie beispielsweise eine gleichartige Aufzugssteuerung verwenden. Gleichartig deshalb, weil zwar die Steuerungshardware und die Steuerungssoftware der Aufzugssteuerung bei allen Produktelinien gleich ist, jedoch für die Steuerungssoftware unterschiedliche, die technischen Unterschiede der Produktelinien berücksichtigenden Parametersätze verwendet werden.

Unterschiedliche Parametersätze sind nicht nur für die verschiedenen Produktelinien erforderlich. Tatsächlich ist auch innerhalb einer Produktelinie jede Kundeninstallation anders, da kundenspezifische Konfigurierungsdaten wie die Stockwerkhöhen, die Grösse der Aufzugskabine, die zu befördernde Masse, die Fahrgeschwindigkeit etc. sehr variabel sind, um die Bedürfnisse der Kunden zu erfüllen, die eine solche Personentransportanlage betreiben. Auch Vorschriften aus Normen wie beispielsweise die maximale Beschleunigung und Verzögerung der Aufzugskabine oder eines Stufenbandes einer Fahrtreppe bestimmen die Parametersätze mit.

Beim Testen einer Produktlinie wird in der Regel eine "repräsentative" Konfiguration gewählt, und die Tests werden mittels dieser Testanlage mit dieser speziellen Konfiguration durchgeführt. Anschliessend werden die Ergebnisse, beispielsweise der für die Aufzugssteuerung einer Aufzugsanlage ermittelte Parametersatz der Testanlage, auf das gesamte Anwendungsgebiet der Produktlinie hochgerechnet. Da es eine begrenzte Anzahl verfügbarer Testtürme gibt, kann zum Beispiel für eine Produktlinie mit einer Förderhöhe bis 50 Meter nur ein Testturm mit einer Förderhöhe von 30 Metern zur Verfügung stehen. Dem entsprechend wird aus der Produktelinie eine Testanlage mit 30 Metern Förderhöhe konfiguriert und zur Ermittlung des Parametersatzes getestet. Dann werden die Ergebnisse auf alle möglichen Konfigurationen der Produktlinie extrapoliert. Die Praxis zeigt jedoch, dass neu installierte Aufzugsanlagen mit einer anderen als der getesteten Förderhöhe hernach konfigurationsbedingte Probleme wie beispielsweise Schwingungsprobleme und damit Lärmprobleme aufweisen können und somit die Extrapolation der Ergebnisse nicht immer zu einem idealen Parametersatz für die Aufzugssteuerung führt. Die Behebung dieser Probleme durch die Anpassung des Parametersatzes erfordert hochqualifiziertes Personal vor Ort und verzögert die Übergabe der fertiggestellten Aufzugsanlage. Dasselbe gilt natürlich nicht nur für die Steuerungssoftware, sondern auch für mechanischen Komponenten, da beispielsweise die auf sie wirkenden, durch Schwingungen verursachte Kräfte ebenfalls stark von der kundenspezifischen Konfiguration abhängen können.

Um physische Komponenten effizienter zu testen, haben sich in den letzten Jahren sogenannte «Hardware in the loop» Testverfahren etabliert. Damit werden Verfahren bezeichnet, bei denen ein eingebettetes System (zum Beispiel ein reales elektronisches Steuergerät oder eine reale mechatronische Komponente, die Hardware) über seine Ein- und Ausgänge an ein angepasstes Gegenstück angeschlossen wird. Letzteres heisst im Allgemeinen HiL-Simulator und dient als Nachbildung der realen Umgebung des Systems. Hardware in the Loop (HiL) ist aus Sicht des Tests eine Methode zum Absichern von eingebetteten Systemen, zur Unterstützung während der Entwicklung sowie zur vorzeitigen Inbetriebnahme von Maschinen und Anlagen.

Das zu steuernde System, beziehungsweise im Sinne der vorliegenden Schrift eine Personentransportanlage, wird über ein Modell simuliert, um die korrekte Funktion beispielsweise der zu entwickelnden Aufzugs-, Fahrtreppen-, oder Fahrsteigsteuerung zu testen. Die HiL-Simulation muss meist in Echtzeit ablaufen und wird in der Entwicklung benutzt, um Entwicklungszeiten zu verkürzen und Kosten zu sparen. Insbesondere lassen sich wiederkehrende Abläufe simulieren. Das hat den Vorteil, dass eine neue Entwicklungsversion unter den gleichen Kriterien getestet werden kann, wie die Vorgängerversion. Somit können die HiL-Simulationen wertvolle Hinweise geben, ob ein Fehler beseitigt wurde oder nicht.

Die Eingänge des Steuergeräts werden mit Sensordaten aus dem Modell stimuliert. Um die Reglerschleife (englisch loop) zu schliessen, wird die Reaktion der Ausgänge des Steuergeräts, zum Beispiel das Ansteuern des Antriebsmotors, der Betriebsbremse, etc., in das Modell zurückgelesen. Der HiL-Simulator besteht also aus einem Rechner, der die Echtzeitbedingungen der jeweiligen Anwendung erfüllen kann und aus digitalen und analogen Ein- und Ausgabe-Schnittstellen zum Steuergerät und zu Ersatzlasten, die der steuergeräteinternen Endstufendiagnose simulieren, dass alle Aktoren korrekt angeschlossen seien. Die Tests an realen Systemen lassen sich dadurch stark verringern und zusätzlich lassen sich Systemgrenzen ermitteln, ohne das Zielsystem (zum Beispiel die Aufzugsanlage und deren Benutzer) zu gefährden.

Die HiL-Simulation ist immer nur eine Vereinfachung der Realität und kann den Test am realen System deshalb nicht ersetzen. Falls zu grosse Diskrepanzen zwischen der HiL-Simulation und der Realität auftreten, ist das zugrundeliegenden Modell in der Simulation zu stark vereinfacht und muss iterativ unter Einsatz aufwändiger, realer Versuchsreihen verbessert werden. Obwohl es durch den technologischen Fortschritt und die Entwicklung von leistungsstarken Mikroprozessoren mittlerweile gelungen ist, dass HiL-Systeme zunehmend die reale Umwelt ersetzen, stellt der HiL-Simulator jedoch immer nur einen begrenzten und grossenteils reduzierten Ausschnitt der realen Umgebungswelt dar.

Eine Umweltsimulation basiert immer nur auf den vorliegenden Erkenntnissen, erhobenen Mess- und Erfahrungswerten, welche in vereinfachte mathematische Formeln überführt werden und sich dann als Modelle im HiL-Simulator wiederfinden. Auf Grund dessen und trotz der Fortschritte in der Umweltsimulation können die bisher bekannten HiL-Simulatoren nur in einem begrenzten Rahmen den Test in der realen Welt ersetzen.

HiL-Verfahren haben sich somit zum Testen von einzelnen Komponenten eines Systems durchgesetzt. Aufgrund der vereinfachten Simulationsmodelle ist es jedoch nicht möglich, das Verhalten des Gesamtsystems wirklichkeitsnah zu testen und im Rahmen dieses Verhaltens des Gesamtsystems ein aussagekräftiges beziehungsweise wirklichkeitsnahes Verhalten einzelner Komponenten dieses Systems herausgelöst betrachten zu können.

Die Aufgabe der vorliegenden Erfindung besteht somit darin, ein Verfahren zum Testen physischer Komponenten einer spezifischen Personentransportanlage anzugeben, welches möglichst präzise Ergebnisse im Hinblick auf die tatsächlich auf dieser Personentransportanlage auftretenden Interaktionen zwischen den verschiedenen Bauteilen liefert, ohne dass die spezifische Personentransportanlage dafür zur Verfügung steht.

Diese Aufgabe wird gelöst durch ein Verfahren zum Testen physischer Komponenten einer Personentransportanlage, wobei die zu testende, physische Komponente über eine physische Schnittstelle mit einer programmierbaren Vorrichtung wirkverbunden werden kann. Dieses Verfahren zeichnet sich dadurch aus, dass auf die programmierbare Vorrichtung ein dreidimensionaler Digitaler-Doppelgänger-Datensatz als Simulationsumgebung geladen wird, der eine ausgewählte Personentransportanlage abbildet und simuliert. Dieser ist jedoch nicht ein einfaches, digitales Modell, sondern der dreidimensionale Digitaler-Doppelgänger-Datensatz ist analog zu der, durch ihn wiedergegebenen physischen Personentransportanlage aus Bauteilmodell-Datensätzen aufgebaut. Wie ihre physischen Pendants weisen die Bauteilmodell-Datensätze Schnittstellen auf, mittles denen sie miteinander verbunden werden und so den dreidimensionalen Digitaler-Doppelgänger-Datensatz bilden. Das bedeutet, dass eine als Flansch mit Bohrungen ausgestaltete Schnittstelle des physischen Bauteils ebenso im diesen wiedergebenden Bauteilmodell-Datensatz abgebildet ist.

Eine ausgewählte Personentransportanlage im Sinne der vorliegenden Schrift ist eine eindeutig konfigurierte Personentransportanlage. Konkret bedeutet dies, dass entweder ein dreidimensionaler Digitaler-Doppelgänger-Datensatz einer bereits bestehenden, physischen Personentransportanlage ausgewählt wird oder mittels kundenspezifischer Konfigurierungsdaten ein dreidimensionaler Digitaler-Doppelgänger-Datensatz aus Bauteilmodell-Datensätzen aufgebaut wird, der eine geplante und damit ebenfalls ausgewählte Personentransportanlage wiedergibt.

Jeder der Bauteilmodell-Datensätze bildet jeweils ein physisches Bauteil der ausgewählten Personentransportanlage durch charakterisierende Eigenschaften ab. Die charakterisierenden Eigenschaften geben zumindest eine strukturelle, eine physikalische und/oder eine zeitgebundene Eigenschaft des abgebildeten physischen Bauteils wieder.

Mit anderen Worten wird der dreidimensionale Digitaler-Doppelgänger-Datensatz einer ausgewählten Personentransportanlage beispielsweise mittels eines Computerprogrammproduktes aus Bauteilmodell-Datensätzen aufgebaut und in einem Speichermedium gespeichert, wobei die Bauteilmodell-Datensätze unterschiedliche Konfigurationen aufweisen können und durch charakterisierende Eigenschaften definiert sind. Jede charakterisierende Eigenschaft eines Bauteilmodell-Datensatzes ist durch einen Vorgabe-Wert vordefiniert, durch einen Soll-Wert vorgegeben, oder durch einen Ist-Wert bestimmt. Üblicherweise bildet ein Bauteilmodell-Datensatz einen physischen Bauteil in seiner Gesamtheit ab, das heisst, dass die Informationen, die die charakterisierenden Eigenschaften liefern, das physische Bauteil möglichst präzise in virtueller Form wiedergeben. Das heisst, dass sich die charakterisierenden Eigenschaften auf einzelne Bauteile beziehen können, aus denen grössere, komplexere Bauteilgruppen zusammengesetzt werden.

Charakterisierenden Eigenschaften eines Bauteilmodell-Datensatzes im Sinne einer strukturellen, physikalischen oder zeitgebundenen Eigenschaft können geometrische Abmessungen, Oberflächen-Beschaffenheiten, physikalische Eigenschaften, dynamische Eigenschaften und dergleichen mehr des durch diesen abgebildeten Bauteil sein. Geometrische Abmessungen können beispielsweise eine Länge, eine Breite, eine Höhe, ein Querschnitt, Radien, Verrundungen, etc. des Bauteils sein. Die Oberflächenbeschaffenheit des Bauteils kann beispielsweise Rauigkeiten, Texturen, Beschichtungen, Farben, Reflektivitäten, etc. umfassen. Physikalische Eigenschaften können das Gewicht beziehungsweise die Materialdichte, den Elastizitätsmodul, die Leitfähigkeit, das Trägheitsmoment, den Biegefestigkeitswert und dergleichen mehr sein. Dynamische Eigenschaften können dem Bauteilmodell-Datensatz zugeordnete Bewegungs-Freiheitsgrade, Geschwindigkeitsprofile und dergleichen mehr sein.

Die charakterisierenden Eigenschaften können sich aber nicht nur auf einzelne Bauteile, sondern auch auf eine Bauteilgruppe beziehen, sofern diese ein in sich abgeschlossenes Teilsystem bildet. Das heisst, dass sich die charakterisierenden Eigenschaften auch auf aus mehreren Bauteilen zusammengesetzte, komplexere Gerätschaften wie zum Beispiel Antriebsmotoren, etc. beziehen können. Logischerweise ist dies nur dann sinnvoll, wenn die zu testende physische Komponente nicht Teil einer solchen Baugruppe ist und wenn das Gesamtverhalten dieser Baugruppe unter den auf sie einwirkenden, äusseren Einflüsse ausreichend bekannt und beschreibbar ist.

Die weiter oben erwähnten Vorgabe-Werte im Sinne der vorliegenden Erfindung sind Werte, die die charakterisierenden Eigenschaften eines Bauteilmodell-Datensatzes vordefinieren. Das heisst beispielsweise, dass ein Vorgabe-Wert eines, als Führungsschienen-Bauteilmodell-Datensatz konfigurierten Bauteilmodell-Datensatzes, der eine Führungsschiene abbildet, im Sinne eines Platzhalters eine Standardlänge definiert. Auch die Querschnittsform dieses Führungsschienen-Bauteilmodell-Datensatzes kann durch Vorgabe-Werte vordefiniert sein. Es ist nun offensichtlich, dass die charakterisierende Eigenschaft des Führungsschienen-Bauteilmodell-Datensatzes, welche die Länge der Führungsschiene repräsentiert, bei der Erstellung des Digitaler-Doppelgänger-Datensatzes angepasst werden muss, während die Querschnittsform gegebenenfalls ausreichend durch die Vorgabe-Werte bereits definiert ist. Auch für charakterisierende Eigenschaften, die materialspezifische Eigenschaften eines Bauteils wie dessen Elastizitätsmodul, dessen Kerbschlagzähigkeit und dergleichen mehr wiedergeben, reichen häufig die aus den Herstellerangaben übernommene Angaben aus.

Soll-Werte im Sinne der vorliegenden Erfindung sind Werte, die die charakterisierenden Eigenschaften eines Bauteilmodell-Datensatzes in einer Soll-Konfiguration definieren. Solche Soll-Werte sind üblicherweise durch kundenspezifische Konfigurierungsdaten bei einer ausgewählten Personentransportanlage definiert oder können auf deren Basis errechnet werden.

Unter kundenspezifischen Konfigurierungsdaten können dabei Vorgaben verstanden werden, welche Einzelfall-spezifisch vom Kunden zum Beispiel beim Ordern der Personentransportanlage vorgegeben werden. Die kundenspezifischen Konfigurierungsdaten beziehen sich dabei auf eine einzelne zu fertigende Personentransportanlage. Beispielsweise können die kundenspezifischen Konfigurierungsdaten vorherrschende räumliche Bedingungen am Einbauort, Schnittstelleninformationen zum Anbau an tragende Strukturen eines Bauwerks, etc. umfassen.

Anders ausgedrückt können die kundenspezifischen Konfigurierungsdaten zum Beispiel angeben, wie viele Stockwerke die Personentransportanlage verbinden soll, die Stockwerkhöhen, in welcher Weise die Personentransportanlage an tragende Strukturen innerhalb des Gebäudes angebunden werden soll, und dergleichen mehr. Kundenspezifische Konfigurierungsdaten können auch Wünsche des Kunden hinsichtlich Funktionalität, Förderkapazität, Optik, etc. umfassen. Die Daten des dreidimensionalen Digitaler-Doppelgänger-Datensatzes können beispielsweise als CAD-Datensatz vorliegen, welcher unter anderem als charakterisierende Eigenschaften geometrische Abmessungen und/oder andere charakterisierende Eigenschaften der die Personentransportanlage bildenden Bauteile wiedergibt.

Das bedeutet, dass beispielsweise bei dem vorangehend erwähnten, als Führungsschienen-Bauteilmodell-Datensatz konfigurierten Bauteilmodell-Datensatz dessen Vorgabe-Wert als die Länge definierende, charakterisierende Eigenschaft durch einen Soll-Wert ersetzt wird, der durch die kundenspezifischen Konfigurierungsdaten vorgegeben wird. Gegebenenfalls ist der Soll-Wert auch noch mit einer Toleranzangabe versehen.

Ist-Werte im Sinne der vorliegenden Erfindung sind Werte, die am physischen Bauteil, welches durch den Bauteilmodell-Datensatz virtuell abgebildet wird, durch Messen, Prüfen und Testen ermittelt wurden.

Je mehr charakterisierende Eigenschaften eines Bauteilmodell-Datensatzes durch einen Ist-Wert definiert sind, desto präziser ist insgesamt die Simulationsumgebung und desto präziser ist der durch das Testen und Optimieren der Aufzugssteuerung in der Simulationsumgebung ermittelte Parametersatz. Aus den vorgenannten Gründen können die Bauteilmodell-Datensätze des als Simulationsumgebung dienenden, dreidimensionalen Digitaler-Doppelgänger-Datensatzes in gemischter Weise durch Vorgabe-Werte, Soll-Werte und Ist-Werte charakterisiert sein.

Zudem weist jeder dieser Bauteilmodell-Datensätze Schnittstelleninformationen zu angrenzenden Bauteilmodell-Datensätzen auf, welche die Zusammenwirkung der miteinander verbundenen Bauteile an der jeweiligen Schnittstelle enthalten. Diese Schnittstelleninformationen können ähnlich der charakterisierenden Merkmale strukturelle, physikalische und/oder zeitgebundene Eigenschaften der Schnittstelle wiedergeben. Dies sind insbesondere Raumkoordinaten, welche die geometrische Position der Schnittstelle am virtuellen Bauteil definieren, statische und/oder dynamische Kräfte und Momente, die an der Schnittstelle wirken können, Informationen über mit dieser Schnittstelle verbindbare Bauteilmodell-Datensätze und dergleichen mehr.

Beispielsweise kann bei einem dreidimensionalen Digitaler-Doppelgänger-Datensatz einer als Aufzugsanlage ausgestalteten Personentransportanlage der virtuelle Schacht mittels mehreren Schachtabschnitt-Bauteilmodell-Datensätzen aufgebaut sein. Diese weisen vordefinierte Schnittstellen auf, über welche Schnittstellen die Schachtabschnitt-Bauteilmodell-Datensätze miteinander verbunden und zueinander positioniert werden können. Zudem ist auch die auf den Schachtabschnitt-Bauteilmodell-Datensatz wirkende Gewichtskraft der über diesem angeordneten Schachtabschnitt-Bauteilmodell-Datensätze als Schnittstelleninformation vorhanden. Je nach vorgesehener Simulation können nun die dazu notwendigen Schnittstelleninformationen herangezogen werden.

Beim vorliegenden Verfahren wird anstelle eines dieser Bauteilmodell-Datensätze, die zu testende physische Komponente über die physische Schnittstelle in die Simulationsumgebung wirkverbunden und mittels einer Testroutine die physische Komponente in der Simulationsumgebung unter Einbindung der Schnittstelleninformationen getestet. Dieser vorangehend erwähnte Bauteilmodell-Datensatz ist logischerweise derjenige, der die zu testende physische Komponente im dreidimensionalen Digitaler-Doppelgänger-Datensatz abbildet. Das Merkmal «anstelle» bedeutet hierbei nicht zwingend, dass dieser Bauteilmodell-Datensatz nicht als Teil des dreidimensionalen Digitaler-Doppelgänger-Datensatzes vorhanden ist, oder im dreidimensionalen Digitaler-Doppelgänger-Datensatz gelöscht oder deaktiviert wird, sondern lediglich, dass während der Durchführung des Verfahrens sichergestellt wird, dass dieser keine Rückwirkungen auf die Testergebnisse hat.

Unter dem Begriff «Testroutine» sind im Wesentlichen eine festgelegte Anzahl von Testabläufen mit gewählten Parametern (Bedingungen) zu verstehen. Hierbei können die Parameter verschiedene Lastfälle, Bremsfälle, Fahrabläufe beziehungsweise Fahrprofile mit Beschleunigungsphase, Fahrphase und Bremsphase und dergleichen mehr umfassen. Konkret werden mit der zu testenden physischen Komponente in der Simulationsumgebung verschiedene Fahrten mit unterschiedlichen Ereignissen simuliert, deren Rückwirkungen als Testergebnisse registriert werden können.

Im Unterschied zu herkömmlichen HiL- Testverfahren wird somit beim erfindungsgemässen Verfahren zum Testen physischer Komponenten einer ausgewählten Personentransportanlage nicht einfach mittels eines rudimentären Testmodells eine Komponente geprüft, sondern einerseits die Komponente selbst und andererseits deren Rückwirkungen auf das gesamte System beziehungsweise auf die ausgewählte Personentransportanlage getestet. Dazu wird ein dreidimensionaler Digitaler-Doppelgänger-Datensatz eingesetzt, der wie die ausgewählte, physische Personentransportanlage aufgebaut ist und somit deren Bauteilstruktur abbildet. Wie bereits vorangehend erläutert, haben hierbei insbesondere auch die Schnittstelleninformationen eine herausragende Bedeutung.

Jeder Bauteilmodell-Datensatz ist in sich gewissermassen eine eigene Teil-Simulationsumgebung, die während des Simulationsprozesses über mehrere Schnittstellen mit angrenzenden Bauteilmodell-Datensätzen interagiert. So können beispielsweise zeitgebunden auftretende Kräfte über eine Kette miteinander interagierende mechanische Bauteile abbildende Bauteilmodell-Datensätze verarbeitet werden, wodurch die Kräfte sich von Bauteilmodell-Datensatz zu Bauteilmodell-Datensatz in ihren Einwirkungen ändern und einige der charakterisierenden Eigenschaften der einzelnen Bauteilmodell-Datensätze zumindest zeitabhängig beeinflussen oder verändern.

Konkret kann die über eine Schnittstelle auf einen Bauteilmodell-Datensatz einwirkende Kraft den Bauteilmodell-Datensatz elastisch deformieren, so dass sich zumindest temporär dessen charakterisierende Eigenschaften, welche die räumlichen Dimensionen definieren, ändern. Ferner werden hierdurch an anderen Schnittstellen zu angrenzenden Bauteilmodell-Datensätzen Kräfte und Momente bewirkt, wobei sich diese in deren Teil-Simulationsumgebung wiederum deren charakterisierenden Eigenschaften entsprechend verhalten und über die Schnittstellen Rückwirkungen erzeugen und sich verändern, bis sich entsprechend dem Einfluss dieser Kräfte im ganzen Gefüge der Bauteilmodell-Datensätze ein neues Gleichgewicht einstellt. Diese Interaktion der verschiedenen Bauteilmodell-Datensätze über die Struktur des dreidimensionalen Digitaler-Doppelgänger-Datensatzes hinweg, ergibt aufgrund ihrer Realitätsnähe hochpräzise, bisher unerreichte Simulationsergebnisse.

Wie bereits weiter oben erwähnt, können aufgrund der Simulationsumgebungs-Struktur, die durch den dreidimensionalen Digitaler-Doppelgänger-Datensatz vorgegebenen ist, zudem für die einzelnen Bauteilmodell-Datensätze auch die für sie geltenden Teil-Simulationsergebnisse betrachtet werden. Insbesondere lassen sich so Grenzen für die einzelnen Bauteilmodell-Datensätze beziehungsweise für die durch sie abgebildeten, physischen Komponenten ermitteln. Wie am vorangehenden Beispiel erläutert, können an den Schnittstellen die auf die mechanischen Bauteile einwirkenden Kräfte durch die Simulation ermittelt werden und mittels finiter Elemente Methoden unter Einbezug der charakterisierenden Eigenschaften des Bauteilmodell-Datensatzes, die Festigkeit dieser Bauteile überprüft werden. Zudem lassen sich durch eine solche strukturierte Simulationsumgebung hervorragend die Auswirkungen von Designänderungen an der zu testenden Komponente auf die angrenzenden und weiter entfernt angeordneten Bauteile und gegebenenfalls auf alle Bauteile der ausgewählten Personentransportanlage überprüfen. Mit anderen Worten lässt sich durch die vorliegende Erfindung auch überprüfen, ob sich bei der zu testenden Komponente zum Beispiel eine als Verbesserung der Steifigkeit eingeführte Formänderung an einer Komponente negativ auf einen anderen Bauteil auswirken kann, der nicht eine direkte Schnittstelle mit dieser Komponente hat, sondern über andere Bauteile mit dieser verbunden ist.

In einer weiteren Ausgestaltung der Erfindung kann der Bauteilmodell-Datensatz der zu testenden, physischen Komponente aktualisiert werden, indem durch das Testen ermittelte Ergebnisse als zusätzliche charakterisierende Eigenschaften diesem Bauteilmodell-Datensatz zugeordnet und/oder vorhandene charakterisierende Eigenschaften und/oder Schnittstelleninformationen aktualisiert werden. Dadurch kann das «Verhalten» der Komponente in der Simulationsumgebung beispielsweise altersbedingten beziehungsweise verschleissbedingten Veränderungen angepasst werden.

In einer weiteren Ausgestaltung der Erfindung kann die physische Schnittstelle von der programmierbaren Vorrichtung entfernt, und das Verhalten des, mit dem aktualisierten Bauteilmodell-Datensatz ergänzten, dreidimensionalen Digitaler-Doppelgänger-Datensatzes mittels der Testroutine verifiziert werden. Sofern die Testergebnisse übereinstimmen, entsprechen die charakterisierenden Eigenschaften des Bauteilmodell-Datensatzes den tatsächlichen physikalischen Eigenschaften der zugeordneten, zu testenden Komponente. Falls eine deutliche Abweichung der Ergebnisse vorliegt, deutet dies darauf hin, dass bei der Aktualisierung ein Fehler unterlaufen ist. Nach der Verifizierung kann dieser Bauteilmodell-Datensatz im Verbund mit den anderen Bauteilmodell-Datensätzen des dreidimensionalen Digitaler-Doppelgänger-Datensatzes verwendet werden, um andere physische Komponenten der Personentransportanlage zu testen, wobei gegebenenfalls eine andere physische Schnittstelle erforderlich ist.

In einer weiteren Ausgestaltung der Erfindung können die Parameter der Testroutine und die Testroutine als charakterisierende Eigenschaften in einem Steuerungs-Bauteilmodell-Datensatz des dreidimensionalen Digitaler-Doppelgänger-Datensatzes gespeichert werden. Hierbei ist insbesondere der Parametersatz für die Steuerung der ausgewählten Personentransportanlage zu erwähnen, der hernach in der Steuerung der physischen Personentransportanlage implementiert wird, wenn diese anhand des als Simulationsumgebung dienenden dreidimensionalen Digitaler-Doppelgänger-Datensatzes, beziehungsweise mittels der ihn bildenden Bauteilmodell-Datensätze hergestellt worden ist.

In einer weiteren Ausgestaltung der Erfindung kann die Testroutine unter Verwendung von Daten einer Daten-Historie eines dreidimensionalen Digitaler-Doppelgänger-Datensatzes generiert werden. In dieser Daten-Historie sind Testroutinen und zugehörende Parameter abgespeichert, welche mit diesem dreidimensionalen Digitaler-Doppelgänger-Datensatz als Simulationsumgebung bereits verwendet wurden. Hierdurch lässt sich die Testroutine verbessern, indem beispielsweise Geschwindigkeitsprofile (Beschleunigungsprofile, Fahrgeschwindigkeitsprofile und Verzögerungsprofile) in Bezug auf den verwendeten dreidimensionalen Digitaler-Doppelgänger-Datensatz optimiert werden.

Des Weiteren kann die getestete physische Komponente anhand der durch das Testen ermittelten Testergebnisse optimiert werden. Mittels der modernen, zur Verfügung stehenden Simulationsmethoden, welche beispielsweise eine Vielzahl von Algorithmen zur geometrischen Analyse, Berechnungsmethoden zur statischen und dynamischen Analyse aus dem Gebiet der Physik, der technischen Mechanik und der Festigkeitslehre, sowie stochastische Berechnungsmetoden und Finite-Elemente-Analysen mit einschliessen, lassen sich im Sinne einer Optimierungsroutine eine Vielzahl verschiedener Szenarien (unterschiedliche Beladung der Aufzugskabine oder des Stufenbandes, verschiedene Geschwindigkeitsprofile, zusätzliche durch charakterisierende Eigenschaften definierte, äussere Einflüsse wie Temperatur, Feuchtigkeit, Luftdruck und dergleichen mehr) für jede Änderung durchrechnen und simulieren, so dass für jede dieser Änderungen und für die Gesamtheit aller Änderungen an dieser physischen Komponente beispielsweise ideale Proportionen, Materialien, Geschwindigkeitsprofile und dergleichen mehr ermittelt werden können, die als charakterisierende Eigenschaften oder Parameter dem Bauteilmodell-Datensatz zugeordnet, gespeichert werden können. Mit anderen Worten werden die charakterisierenden Eigenschaften der zu testenden, physischen Komponente mittels einer Optimierungsroutine nach vorgebbaren Qualitätskriterien in der Simulationsumgebung ermittelt. Die vorgegebenen Qualitätskriterien sind hierbei beispielsweise vorgesehene Sicherheitsfaktoren gegen Bruch, Toleranzangaben bezüglich der maximal zulässigen Schwingungsamplituden eines durch die Bauteilmodell-Datensätze und die zu testende physische Komponente gebildeten Schwingsystems, für den Benutzer der Personentransportanlage angenehme Beschleunigungen und Verzögerungen bei einer möglichst kurzen Dauer der Fahrt, Vorgaben aus nationalen und internationalen Normen und dergleichen mehr.

In einer weiteren Ausgestaltung der Erfindung kann mittels einer Suchroutine anhand von charakterisierenden Eigenschaften und/oder Kennzeichen der zu testenden, physischen Komponente in einem Speichermedium ein korrespondierender Bauteilmodell-Datensatz gesucht werden. Sofern ein solcher gefunden wird, können vorhandene, dreidimensionale Digitaler Doppelgänger-Datensätze nach diesem Bauteilmodell-Datensatz durchsucht werden. Die diesen Bauteilmodell-Datensatz aufweisenden, dreidimensionalen Digitaler-Doppelgänger-Datensätze können dann als Simulationsumgebung zur Auswahl vorgeschlagen werden. Diese Funktionalität hat den Vorteil, dass bei einer Änderung der physischen Komponente deren Auswirkungen auch auf andere dreidimensionale Digitaler-Doppelgänger-Datensätze beziehungsweise Personentransportanlagen überprüft und verifiziert werden kann.

In einer weiteren Ausgestaltung der Erfindung kann der dreidimensionale Digitaler-Doppelgänger-Datensatz der Personentransportanlage mittels eines Computerprogrammproduktes unter Berücksichtigung von zuvor erhobenen, kundenspezifischen Konfigurierungsdaten aus Bauteilmodell-Datensätzen aufgebaut und in einem Speichermedium gespeichert werden. Wie bereits weiter oben ausführlich beschrieben, können die Bauteilmodell-Datensätze hierbei unterschiedliche Konfigurationen aufweisen und sind durch charakterisierende Eigenschaften definiert. Jede charakterisierende Eigenschaft ist durch einen Vorgabe-Wert vordefiniert, durch einen Soll-Wert vorgegeben, oder durch einen Ist-Wert bestimmt. Die ausführlichen Definitionen zu diesen Werten sind weiter unten im Zusammenhang mit der Figurenbeschreibung zu finden.

In einer weiteren Ausgestaltung der Erfindung können vor dem Testen der physischen Komponente Schnittstelleninformationen derjenigen Bauteilmodell-Datensätze ausgelesen werden, die dem Bauteilmodell-Datensatz angrenzend angeordnet sind, dessen zugeordnete physische Komponente getestet werden soll. Anhand dieser ausgelesenen Schnittstelleninformationen kann die physische Schnittstelle zur Wirkverbindung der programmierbaren Vorrichtung mit der zu testenden physischen Komponente bereitgestellt und konfiguriert werden. Je nach Aufgabe und Ausgestaltung dieser physischen Schnittstelle kann in und/oder an dieser zudem eine geeignete Sensorik verbaut sein, um die aus den Tests resultierenden Testergebnisse in maschinenlesbarer Form zu erfassen und verfügbar zu machen. Insbesondere bei physischen Schnittstellen zum Verbinden von mechanisch zu testenden physischen Komponenten mit der programmierbaren Vorrichtung können Kraftmesssensoren, Beschleunigungssensoren, bildgebende Sensoren, Distanzmesssensoren und dergleichen mehr vorhanden sein.

In einer weiteren Ausgestaltung der Erfindung kann anhand der ausgelesenen Schnittstelleninformationen aus verfügbaren physischen Schnittstellen diejenige ausgewählt werden, welche die meisten der ausgelesenen Schnittstelleninformationen verwirklicht. Dadurch lässt sich ein erforderlicher Aufwand zum Anpassen einer physischen Schnittstelle automatisiert minimieren und zudem lassen sich die bereits vorhandenen, physischen Schnittstellen effizient bewirtschaften.

In einer weiteren Ausgestaltung der Erfindung kann die ausgewählte physische Schnittstelle auf fehlende Schnittstellenübereinstimmungen überprüft, und die differierenden Schnittstelleninformationen können über eine Ausgabeschnittstelle ausgegeben werden. Hierdurch wird ersichtlich, welche Änderungen an der ausgewählten physischen Schnittstelle gemacht werden müssen, damit die programmierbare Vorrichtung beziehungsweise die Simulationsumgebung mit der zu testenden, physischen Komponente verbunden werden kann.

In einer weiteren Ausgestaltung der Erfindung kann aus den differierenden Schnittstelleninformationen Adaptermittel erzeugt, und mit diesen die physische Schnittstelle einsatzbereit gemacht werden. Mit anderen Worten ausgedrückt, muss die Schnittstelle nicht zwingend umgebaut werden, sondern kann auch mittels Adaptermittel angepasst werden. Diese Adaptermittel können elektrische Steckerverbindungen sowie mechanische Adaptermittel wie Flanschverbindungen, Aufnahmen und dergleichen mehr sein, aber auch Software-Adaptermittel wie zum Beispiel spezifische Schnittstellen-Programmmodule, Transferprotokolle, Compiler, etc.

In einer weiteren Ausgestaltung der Erfindung können aus den ausgelesenen Schnittstelleninformationen dynamische charakterisierende Eigenschaften identifiziert und diese an Aktuatoren der physischen Schnittstelle übertragen werden. Mit anderen Worten können bei mechanischen Komponenten, die getestet werden sollen, Aktuatoren die an deren Schnittstellen auftretenden Bewegungen, Kräfte und Momente erzeugen. So lassen sich die aus den Simulationen ergebenden Belastungen auf das zu testende Bauteil übertragen und dessen tatsächliches Verhalten unter den in der Simulationsumgebung ermittelten Belastungen untersuchen.

Die vorangehend beschriebenen Verfahrensschritte sind vorzugsweise in einem Computerprogrammprodukt, umfassend maschinenlesbare Programmanweisungen implementiert, welche bei Ausführung auf einer programmierbaren Vorrichtung die programmierbare Vorrichtung zum Durchführen oder Steuern dieser Verfahrensschritte veranlassen. Im Computerprogrammprodukt können insbesondere auch Verfahrensschritte zur Erstellung des dreidimensionalen Digitaler-Doppelgänger-Datensatzes und gegebenenfalls auch die zur Erstellung erforderlichen Bauteilmodell-Datensätze implementiert sein.

Je genauer der dreidimensionale Digitaler-Doppelgänger-Datensatz die ausgewählte, das heisst, eine bestehende oder geplante Personentransportanlage abbildet, desto präziser kann eine physische Komponente getestet werden. Wenn beispielsweise als physische Komponente eine Aufzugssteuerung der ausgewählten Personentransportanlage getestet wird, kann ein für diese hervorragend optimierter Parametersatz ermittelt werden, obwohl diese Personentransportanlage mit Ausnahme ihrer Aufzugssteuerung noch gar nicht physisch existiert. Dieser optimierte Parametersatz kann hernach in die Aufzugssteuerung der physischen Personentransportanlage übernommen werden und es ist anzunehmen, dass dieser bereits bei der Inbetriebnahme der Personentransportanlage perfekte Resultate hinsichtlich deren Betriebsverhaltens liefert.

Wie bereits weiter oben erwähnt, kann zur Durchführung des Verfahrens eine programmierbare Vorrichtung und ein Computerprogrammprodukt mit maschinenlesbaren Programmanweisungen verwendet werden. Dabei kann die programmierbare Vorrichtung ein Einzelgerät wie beispielsweise ein Personal Computer, ein Laptop, ein Mobiltelefon, ein Tablet, eine Steuerung einer Personentransportanlage oder dergleichen mehr sein. Die programmierbare Vorrichtung kann aber auch einen oder mehrere Computer umfassen. Insbesondere kann die programmierbare Vorrichtung aus einem Computernetzwerk gebildet sein, welches Daten in Form einer Datenwolke (Cloud) verarbeitet. Die programmierbare Vorrichtung kann hierfür über einen Speicher verfügen, in dem die Daten des dreidimensionalen Digitaler-Doppelgänger-Datensatzes und die zu dessen Erstellung erforderlichen Bauteilmodell-Datensätze verschiedener Konfiguration gespeichert werden können, beispielsweise in elektronischer oder magnetischer Form. Die programmierbare Vorrichtung kann ferner über Datenverarbeitungsmöglichkeiten verfügen. Beispielsweise kann die programmierbare Vorrichtung einen Prozessor aufweisen, mithilfe dessen Daten all dieser Datensätze und die maschinenlesbaren Programmanweisungen des Computerprogrammprodukts verarbeitet werden können. Die programmierbare Vorrichtung kann ferner über Datenschnittstellen verfügen, über die Daten in die programmierbare Vorrichtung eingegeben und/oder aus der programmierbaren Vorrichtung ausgegeben werden können. Die programmierbare Vorrichtung kann auch räumlich verteilt implementiert sein, beispielsweise wenn Daten über mehrere Computer verteilt in einer Datenwolke (Cloud) verarbeitet werden.

Insbesondere kann die programmierbare Vorrichtung programmierbar sein, das heisst durch ein geeignet programmiertes Computerprogrammprodukt dazu veranlasst werden, Computer- verarbeitbare Schritte und Daten der erfindungsgemässen Verfahren auszuführen oder zu steuern. Das Computerprogrammprodukt kann Anweisungen oder Code enthalten, welche beispielsweise den Prozessor der Vorrichtung dazu veranlassen, Daten des dreidimensionalen Digitaler-Doppelgänger-Datensatzes zu erstellen, abzuspeichern, auszulesen, zu verarbeiten, zu modifizieren, etc. Das Computerprogrammprodukt kann in einer beliebigen Computersprache verfasst sein.

Durch das Ausführen des Computerprogrammprodukts auf der programmierbaren Vorrichtung kann unter Berücksichtigung der zuvor erfassten, kundenspezifischen Konfigurierungsdaten ein dreidimensionaler Digitaler-Doppelgänger-Datensatz aus Bauteilmodell-Datensätzen aufgebaut und in einem Speichermedium der programmierbaren Vorrichtung gespeichert werden. Die zu diesem Zwecke aus einem Speichermedium, abrufbaren Bauteilmodell-Datensätze weisen unterschiedliche Konfigurationen auf und sind durch charakterisierende Eigenschaften definiert, die mit Vorgabe-Werten vordefiniert sind. Das Speichermedium mit den Bauteilmodell-Datensätzen ist vorzugsweise ebenfalls in der Datenwolke verwirklicht, es kann aber auch als Datenbank ausgestaltet, Teil des Computerprogrammproduktes sein.

Zusammenfassend kann gesagt werden, dass das Computerprogrammprodukt maschinenlesbare Programmanweisungen umfasst, welche bei Ausführung auf einer programmierbaren Vorrichtung die Vorrichtung zum Durchführen oder Steuern der weiter oben beschriebenen Ausführungen des erfindungsgemässen Verfahrens veranlassen.

Das Computerprogrammprodukt kann auf einem beliebigen computerlesbaren Medium gespeichert sein, beispielsweise einem Flash-Speicher, einer CD, einer DVD, RAM, ROM, PROM, EPROM, einer Diskette und dergleichen mehr. Das Computerprogrammprodukt und/oder die damit zu verarbeitenden Daten können auch auf einem Server oder mehreren Servern gespeichert sein, beispielsweise in einer Datenwolke, von wo aus sie über ein Netz, beispielsweise das Internet, heruntergeladen werden können.

Abschliessend wird daraufhingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, übertragen, angepasst oder ausgetauscht werden können, um zu weiteren Ausführungsformen der Erfindung zu gelangen.

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind. Mehrere Bezugszeichen, welche mittels eines Schrägstrichs zueinander angeordnet sind, symbolisieren Doppelbezeichnungen für dasselbe Bauteil beziehungsweise dieselbe Komponente. Es zeigen:
- Figur 1:: schematisch in dreidimensionaler Ansicht ein Testaufbau zur Durchführung der vorangehend beschriebenen Verfahren zum Testen physischer Komponenten;
- Figur 2:: schematisch in dreidimensionaler Ansicht die wesentlichen Verfahrensschritte zur Erstellung eines dreidimensionalen Digitaler-Doppelgänger-Datensatzes einer ausgewählten Personentransportanlage, der als Simulationsumgebung im erfindungsgemässen Verfahren verwendet werden kann;
- Figur 3:: schematisch die wichtigsten Interaktionen einer Suchroutine zur Identifizierung von auswählbaren, Personentransportanlagen abbildenden dreidimensionalen Digitaler-Doppelgänger-Datensätzen, die geeignet sind, als Simulationsumgebung für die zu testende Komponente zu dienen;
- Figur 4:: schematisch verschiedene Verfahrensschritte zur Bereitstellung einer geeigneten Schnittstelle, damit die zu testende physische Komponente mit der Simulationsumgebung verbunden werden kann.

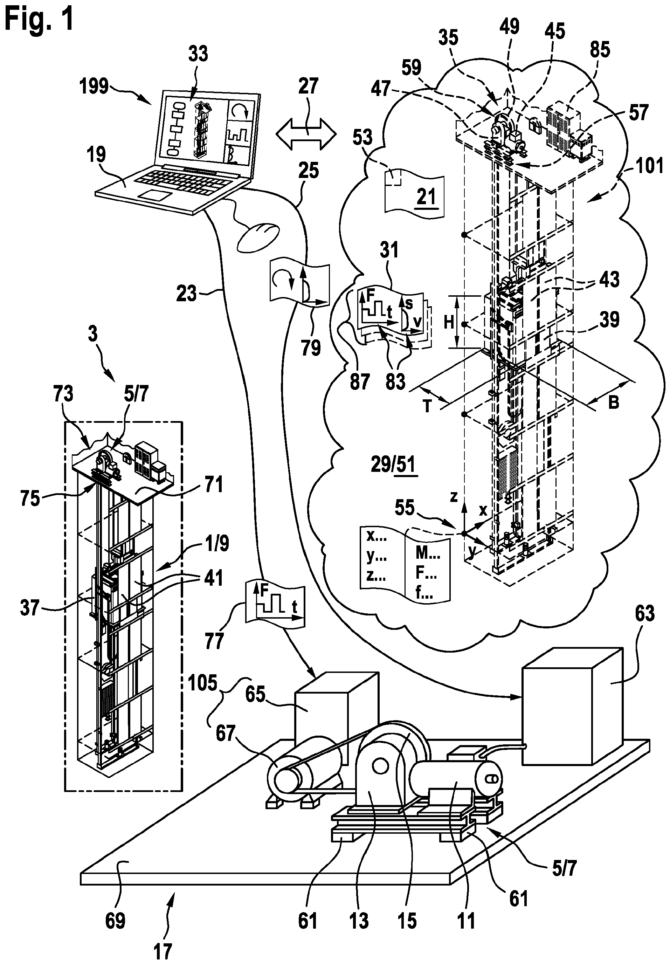

Die Figur 1 zeigt schematisch in dreidimensionaler Ansicht einen Testaufbau 3 zur Durchführung eines Verfahrens 199 zum Testen einer physischen Komponente 5 einer Personentransportanlage 1. Da diese Personentransportanlage 1 ausser ihrer zu testenden Komponente 5 gegebenenfalls noch nicht physisch existiert, wird hierfür ein dreidimensionaler Digitaler-Doppelgänger-Datensatz 101 als Simulationsumgebung 33 ausgewählt.

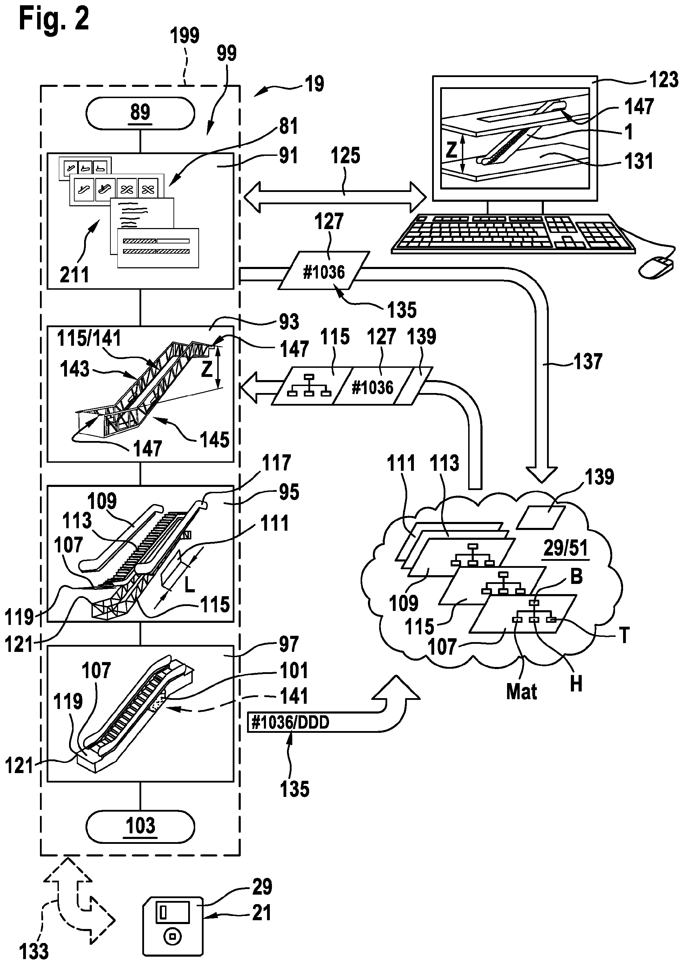

Der Begriff «ausgewählt» bedeutet im Zusammenhang mit der vorliegenden Erfindung, dass ein dreidimensionaler Digitaler-Doppelgänger-Datensatz 101 einer bestehenden Personentransportanlage 1 ausgewählt wird, die dieser nichtexistierenden, aber geplanten Personentransportanlage 1 entspricht. Sofern aber kein solcher Digitaler-Doppelgänger-Datensatz 101 existiert, kann wie in der Figur 2 anhand einer als Fahrtreppe ausgestalteten Personentransportanlage 1 ausführlich erklärt wird, von der Personentransportanlage 1 ein dreidimensionaler Digitaler-Doppelgänger-Datensatz 101 erstellt werden, indem dieser mittels auswählbaren, kundenspezifischen Konfigurierungsdaten 81 konfiguriert wird. Um die physische «Nichtexistenz» der Personentransportanlage 1 symbolisch anzuzeigen, ist diese in der Figur 1 durch eine strichdoppelpunktierte Linie umrahmt.

Im vorliegende Ausführungsbeispiel der Figur 1 soll als physische Komponente 5 eine Antriebseinheit 7 der als Aufzugsanlage 9 konzipierten Personentransportanlage 1 getestet werden. Beispielsweise können durch einen solchen Test das Zusammenwirken von Antriebsmotor 11, Getriebe 13 und Treibscheibe 15 unter wirklichkeitsnahen Belastungen überprüft, und hierbei mögliche Schwachstellen oder negative Rückwirkungen auf andere Komponenten der ausgewählten Personentransportanlage 1 eruiert werden.

Wie dargestellt, wird die zu testende, physische Komponente 5 über eine physische Schnittstelle 17 mit einer programmierbaren Vorrichtung 19 wirkverbunden.

Die programmierbare Vorrichtung 19 kann ein Einzelgerät wie beispielsweise ein Personal Computer, der dargestellte Laptop, ein Mobiltelefon, ein Tablet, eine Steuerung einer Personentransportanlage 1 oder dergleichen mehr sein. Die programmierbare Vorrichtung 19 kann aber auch einen oder mehrere Computer umfassen. Insbesondere kann die programmierbare Vorrichtung aus einem Computernetzwerk gebildet sein, welches Daten in Form einer Datenwolke 51 (Cloud) verarbeitet. Die programmierbare Vorrichtung 19 kann hierfür über einen Speicher verfügen, in dem die Daten des dreidimensionalen Digitaler-Doppelgänger-Datensatzes 101 und die zu dessen Erstellung erforderlichen Bauteilmodell-Datensätze 39, 43, 45, 47, 49 (siehe auch Figur 2) verschiedener Konfiguration gespeichert werden können, beispielsweise in elektronischer oder magnetischer Form. Die programmierbare Vorrichtung 19 kann ferner über Datenverarbeitungsmöglichkeiten verfügen. Beispielsweise kann die programmierbare Vorrichtung 19 einen Prozessor aufweisen, mithilfe dessen Daten all dieser Datensätze und die maschinenlesbaren Programmanweisungen des weiter unten beschriebenen Computerprogrammprodukts 21 verarbeitet werden können. Die programmierbare Vorrichtung 19 kann ferner über Datenschnittstellen 23, 25, 27 verfügen, über die Daten in die programmierbare Vorrichtung 19 eingegeben und/oder aus der programmierbaren Vorrichtung 19 ausgegeben werden können. Die programmierbare Vorrichtung 19 kann auch räumlich verteilt implementiert sein, beispielsweise wenn Daten über mehrere Computer verteilt in einer Datenwolke 51 (Cloud) verarbeitet werden. In dieser können beispielsweise auch das vorangehend erwähnte Computerprogrammprodukt 21, Testroutinen 31 und dergleichen mehr gespeichert sein und verarbeitet werden.

Des Weiteren wird auf die programmierbare Vorrichtung 19 aus einem Speichermedium 29, im vorliegenden Ausführungsbeispiel aus der Datenwolke 51 der dreidimensionale Digitaler-Doppelgänger-Datensatz 101 als Simulationsumgebung 33 geladen, der die ausgewählte Personentransportanlage 1 abbildet und simuliert. Als Speichermedium 29 können hierbei jede bekannte Art von Datenspeichern verwendet werden.

Die Simulationsumgebung 33 auf der Basis des dreidimensionalen Digitaler-Doppelgänger-Datensatzes 101 ermöglicht eine dynamische Echtzeit-Simulation der ausgewählten Personentransportanlage 1 und liefert äusserst präzise Simulationsergebnisse, da der dreidimensionale Digitaler-Doppelgänger-Datensatz 101 analog zu der, durch ihn wiedergegebenen physischen Personentransportanlage 1 aus Bauteilmodell-Datensätzen 39, 43, 45, 47, 49 aufgebaut wird.

Jeder dieser Bauteilmodell-Datensätze 39, 43, 45, 47, 49 bildet jeweils ein geplantes oder tatsächlich existierendes physisches Bauteil 11, 13, 15, 37, 41 der ausgewählten Personentransportanlage 1 durch charakterisierende Eigenschaften B, T, H ab. So wird beispielsweise eine Aufzugskabine 37 durch einen Aufzugskabinen-Bauteilmodell-Datensatz 39, eine Schachttüre 41 durch einen Schachttür-Bauteilmodell-Datensatz 43, der Antriebsmotor 11 durch einen Antriebsmotor-Bauteilmodell-Datensatz 45, das Getriebe 13 durch einen Getriebe- Bauteilmodell-Datensatz 47, die Treibscheibe 15 durch einen Treibscheiben- Bauteilmodell-Datensatz 49, usw. abgebildet.

Eine charakterisierende Eigenschaft B, T, H gibt hierbei zumindest eine strukturelle, eine physikalische und/oder eine zeitgebundene Eigenschaft des abgebildeten physischen Bauteils 11, 13, 15, 37, 41 wieder. Charakterisierenden Eigenschaften B, T, H eines Bauteilmodell-Datensatzes 39, 43, 45, 47, 49 im Sinne einer strukturellen, physikalischen oder zeitgebundenen Eigenschaft können geometrische Abmessungen, Oberflächen-Beschaffenheiten, physikalische Eigenschaften, dynamische Eigenschaften und dergleichen mehr des durch diese abgebildeten Bauteils sein. Geometrische Abmessungen können beispielsweise eine Länge, eine Breite, eine Höhe, ein Querschnitt, Radien, Verrundungen, etc. des Bauteils sein. Beispielhaft sei an dieser Stelle, der in der Figur 1 dargestellte Aufzugskabinen-Bauteilmodell-Datensatz 39 erwähnt, dessen Innenraum-Abmasse durch die charakterisierenden Eigenschaften B, T, H definiert sind.

Logischerweise weist eine Aufzugskabine 37 eine Vielzahl von Einzelteilen auf, die zusammengesetzt die Aufzugskabine 37 bilden. Alle diese Einzelteile sind vorzugsweise als einzelne Bauteilmodell-Datensätze im dreidimensionalen Digitaler-Doppelgänger-Datensatz 101 abgebildet und nicht die Aufzugskabine 37 als ein gesamter Bauteilmodell-Datensatz 39, da sonst beispielsweise mechanische Belastungen, Elastizitäten, etc. in den Fügestellen dieser Einzelteile bei den Tests nicht ausreichend betrachtet werden können.

Die Oberflächenbeschaffenheit des Bauteils kann beispielsweise Rauigkeiten, Texturen, Beschichtungen, Farben, Reflektivitäten, etc. umfassen. Physikalische Eigenschaften können das Gewicht beziehungsweise die Materialdichte, den Elastizitätsmodul, die Leitfähigkeit, das Trägheitsmoment, den Biegefestigkeitswert und dergleichen mehr sein. Dynamische Eigenschaften können dem Bauteilmodell-Datensatz zugeordnete Bewegungs-Freiheitsgrade, Geschwindigkeitsprofile und dergleichen mehr sein.

Durch diese Datenstruktur verhalten sich die Bauteilmodell-Datensätze 39, 43, 45, 47, 49 in der Simulationsumgebung 33 wie ihre physischen Pendants und jeder trägt mit seinem, durch die charakterisierenden Eigenschaften B, T, H vorgegebenen, spezifischen Verhalten zu den Simulationsergebnissen bei, selbst wenn ein Bauteilmodell-Datensatz 39, 43, 45, 47, 49 keine unmittelbare Schnittstelle 55, 57, 59 zur zu testenden physischen Komponente 5 hat. Logischerweise ist nebst dem dreidimensionalen Digitaler-Doppelgänger-Datensatz 101, der die Basis der Simulationsumgebung 33 bildet, zur Durchführung der Tests beziehungsweise zum Betreiben der Simulationsumgebung 33 eine Simulationssoftware 53 erforderlich, in welche die dazu notwendigen Algorithmen implementiert sind. Diese kann wie dargestellt, auch Teil des Computerprogrammproduktes 21 sein. Gegebenenfalls ist die Simulationssoftware 53 auch in der Lage, sich weiterer Softwareprogramme zu bedienen, diese in die Simulationsumgebung 33 aktiv einzubinden und deren Aktivitäten zu koordinieren.

Damit aber ein Bauteilmodell-Datensatz 39, 43, 45, 47, 49 mit einem angrenzenden Bauteilmodell-Datensatz 39, 43, 45, 47, 49 interagieren kann, muss jeder dieser Bauteilmodell-Datensätze 39, 43, 45, 47, 49 Schnittstellen 55, 57, 59 mit Schnittstelleninformationen x, y, z, F, M, f, ... zu angrenzenden Bauteilmodell-Datensätzen 39, 43, 45, 47, 49 aufweisen, welche die Zusammenwirkung der miteinander verbundenen Bauteilmodell-Datensätze 39, 43, 45, 47, 49 an der jeweiligen Schnittstelle 55, 57, 59 enthält. Darunter sind nicht nur geometrische Daten wie Raumkoordinaten x, y, z zu verstehen, durch welche definiert wird, wo der Bauteilmodell-Datensatz 39, 43, 45, 47, 49 mit dem dort angrenzenden Bauteilmodell-Datensatz 39, 43, 45, 47, 49 verbunden wird. Es werden beispielsweise auch dynamische Schnittstelleninformationen über diese weitergeleitet, so zum Beispiel an der Schnittstelle 55, 57, 59 auftretende Kräfte F, Schwingungsfrequenzen f, durch festgezogene Schrauben hervorgerufenen Spannungen in den Verbindungsflanschen der zu testenden physischen Komponente 5 und dergleichen mehr. Diese Schnittstelleninformationen x, y, z, F, M, f, ... können während der Simulation zeitgebundenen Veränderungen unterworfen sein, insbesondere sind hiervon die dynamischen Schnittstelleninformationen betroffen.

Wie bereits erwähnt, wird die zu testende physische Komponente 5 über die physische Schnittstelle 17 in die Simulationsumgebung 33 wirkverbunden und tritt somit an die Stelle des Bauteilmodell-Datensatzes 35, welcher die zu testende physische Komponente 5 im dreidimensionalen Digitaler-Doppelgänger-Datensatz abbildet. Die physische Schnittstelle 17 ist so aufgebaut, dass alle Schnittstellen 55, 57, 59 der an die zu testenden Komponente 5 angrenzenden Bauteile beziehungsweise von deren Bauteilmodell-Datensätzen in geeigneter Weise wiedergegeben sind.

Im vorliegenden Ausführungsbeispiel weist die physische Schnittstelle 17 Befestigungsbereiche 61, eine Aufzugssteuerung 63 sowie einen mit zugehörender Generatorsteuerung 65 versehener Generator 67 auf. Die Befestigungsbereiche 61 sind auf einer Basisplatte 69 angeordnet, welche auch die übrigen Teile der physischen Schnittstelle 17 aufnimmt. Die Befestigungsbereiche 61 sind im Wesentlichen statische Schnittstellen 57, welche den im Boden 71 eines Maschinenraumes 73 ausgebildeten Verankerungsstellen 75 entsprechen und die von der physischen Komponente 5 erzeugten Kräfte F und Momente M aufnehmen. Gegebenenfalls können die Befestigungsbereiche 61 mit nicht dargestellten Kraftmessvorrichtungen bestückt sein, damit die Kräfte gemessen, und in die Simulationsumgebung 33 an den entsprechenden Schnittstellen 55, 57, 59 der angrenzenden Bauteilmodell-Datensätze 39, 43, 45, 47, 49 übertragen werden.

Der Generator 67 ist mechanisch mit der Treibscheibe 15 drehmomentübertragend verbunden und erzeugt die an der Treibscheibe 15 wirkende Belastung, indem die Generatorsteuerung 65 einen am Generator 67 angeschlossenen elektrischen Verbraucher entsprechend einem durch die Testroutine 31 vorgegebenen Belastungsprofil 77 über die Zeit regelt. Somit wirkt der Generator 67 und die Generatorsteuerung als Aktuator 105, der aus der Simulationsumgebung 33 generierte Belastungen gemäss dem vorgegebenen Belastungsprofil 77 umsetzt. Diesem Belastungsprofil 77 liegt jedoch nicht nur die Testroutine 31 zugrunde, sondern auch ausgelesene Schnittstelleninformationen x, y, z, F, M, f, ..., bei denen insbesondere dynamische charakterisierende Eigenschaften identifiziert und diese an die Aktuatoren 105 der physischen Schnittstelle 17 übertragen werden. Im vorliegenden Ausführungsbeispiel kann beispielsweise die Testroutine 31 wechselnde Beladungen der Aufzugskabine 37 vorgeben, während aus der Simulationsumgebung 33 durch das simulierte Fahrverhalten der Aufzugskabine 37 zusätzliche, lastabhängige Schwingungen auftreten können, die an den Schnittstellen 55, 57, 59 als Schnittstelleninformationen x, y, z, F, M, f, ...übertragen werden und somit ebenfalls durch den Aktuator 105 an der richtigen Schnittstelle auf die zu testende, physische Komponente 5 übertragen werden muss. Mit anderen Worten können bei mechanischen Komponenten, die getestet werden sollen, Aktuatoren 105 die an deren Schnittstellen 55, 57, 59 auftretenden Bewegungen, Kräfte und Momente erzeugen. So lassen sich die aus den Simulationen ergebenden Belastungen auf das zu testende Bauteil übertragen und dessen tatsächliches Verhalten unter den in der Simulationsumgebung 33 ermittelten Belastungen untersuchen.

Sobald der Testaufbau 3 steht und die programmierbare Vorrichtung 19 mittels des Computerprogrammproduktes 21 die Simulationsumgebung 33 unter Einbezug des ausgewählten dreidimensionalen Digitaler-Doppelgänger-Datensatzes 101 und zugehörender Simulationssoftware 53 mit Testroutinen 31 aufgebaut hat, kann das Testen der physischen Komponente 5 der ausgewählten Personentransportanlage 1 durchgeführt werden. Mittels der Testroutine 31 wird die physische Komponente 5 in der Simulationsumgebung 33 unter Einbindung des dreidimensionalen Digitaler-Doppelgänger-Datensatzes 101, der Simulationssoftware 53 und der Schnittstelleninformationen x, y, z, F, M, f, ... getestet. Die Testroutine 31 bildet hierbei verschiedene Betriebsmodi und Betriebszustände ab. So kann die programmierbare Vorrichtung 19 entsprechend dem Zeitablauf der Testroutine 31 zum Beispiel Belastungsprofile 77 an die Generatorsteuerung 65 senden, die die zu befördernde Last der Aufzugskabine 37, oder genauer ausgedrückt, von dessen Aufzugskabinen-Bauteilmodell-Datensatz 39 wiedergeben. Des Weiteren können entsprechend dem Zeitablauf der Testroutine 31 beispielsweise Bewegungsprofile 79 an die Aufzugssteuerung 63 übertragen werden, die insbesondere verschiedenste Zielrufe simulieren und gegebenenfalls die Aufzugssteuerung 63 dazu veranlassen, das Geschwindigkeitsprofil der virtuellen Aufzugskabine beziehungsweise der diese bildenden Bauteilmodell-Datensätze 39 zu verändern.

Aufgrund der durchgeführten Tests können gegebenenfalls Änderungen an der getesteten, physischen Komponente 5 erforderlich sein. Hierbei kann die geänderte physische Komponente 5 wiederum in der Simulationsumgebung 33 getestet werden, um die Auswirkungen und Rückwirkungen der Änderungen auf die anderen Komponenten beziehungsweise auf die sie abbildenden Bauteilmodell-Datensätze 39, 43, 45, 47, 49 überprüfen zu können.

Diese Änderungen sind selbstverständlich auch im entsprechenden Bauteilmodell-Datensatz 35 nachzuführen, der dieser physischen Komponente 5 zugeordnet ist..Wie bereits weiter oben erwähnt, kann ein Bauteilmodell-Datensatz 35, 39, 43, 45, 47, 49 mittels verschiedenster charakterisierenden Eigenschaften B, T, H, ... beschrieben und definiert werden. Um diese noch weiter zu verfeinern, kann nach den Tests der Bauteilmodell-Datensatz 35 der zu testenden, physischen Komponente 5 aktualisiert werden, indem durch das Testen ermittelte Ergebnisse als zusätzliche charakterisierende Eigenschaften B, T, H, ... diesem Bauteilmodell-Datensatz 35 zugeordnet und/oder vorhandene charakterisierende Eigenschaften B, T, H, ... und/oder Schnittstelleninformationen x, y, z, F, M, f, ... aktualisiert werden.

Nach dem Testen der physischen Komponente 5 kann die physische Schnittstelle 17 von der programmierbaren Vorrichtung 19 entfernt werden, um danach das Verhalten des, mit dem aktualisierten Bauteilmodell-Datensatz 35 ergänzten, dreidimensionalen Digitaler-Doppelgänger-Datensatz 101 mittels der Testroutine 31 zu verifizieren. Mit anderen Worten wird der reine, dreidimensionale Digitaler-Doppelgänger-Datensatz 101 in aktualisierter Form nochmals getestet, um eventuelle Verhaltensabweichungen zwischen der physischen Komponente 5 und deren Bauteilmodell-Datensatz 35 festzustellen und gegebenenfalls durch Anpassungen der charakterisierenden Eigenschaften B, T, H, ... und/oder Schnittstelleninformationen x, y, z, F, M, f, ... des Bauteilmodell-Datensatzes 35 zu beheben.

Des Weiteren können Parameter 83 der Testroutine 31 und die Testroutine 31 als charakterisierende Eigenschaften B, T, H, ... in einem Steuerungs-Bauteilmodell-Datensatz 85 des dreidimensionalen Digitaler-Doppelgänger-Datensatzes 101 gespeichert werden. Dies hat den Vorteil, dass alle Angaben zu den Simulationsergebnissen stets vorhanden sind und falls Probleme mit der entsprechenden physischen Personentransportanlage 1 auftreten, besser analysiert werden kann, warum diese Probleme in der Simulationsumgebung nicht aufgetreten sind.

Durch diese zugeordnete Speicherung der Testroutine 31 und der Parameter 83 ist es auch möglich, eine neue Testroutine 31 unter Verwendung von Daten einer Daten-Historie 87 eines dreidimensionalen Digitaler-Doppelgänger-Datensatzes 101 zu generieren, wobei in dieser Daten-Historie 87 Testroutinen 31 und zugehörende Parameter 83 abgespeichert sind, welche mit diesem dreidimensionalen Digitaler-Doppelgänger-Datensatz 101 bereits durchgeführt wurden.

Die Figur 2 zeigt ein mit zusätzlichen Informationen versehenes Diagramm zur Veranschaulichung von Verfahrensschritten Diese Änderungen sind selbstverständlich auch im entsprechenden Bauteilmodell-Datensatz 35 nachzuführen, der dieser physischen Komponente 5 zugeordnet ist eines Teil-Verfahrens 99 zur Erstellung eines dreidimensionalen Digitaler-Doppelgänger-Datensatzes 101 einer Personentransportanlage 1, dessen graphische Repräsentation im vorliegenden Beispiel eine Fahrtreppe darstellt. Diese Verfahrensschritte 91, 93, 95, 97 können ebenfalls Teil des Verfahrens 199 sein, welches im Computerprogrammprodukt 21 implementiert ist. Diese Verfahrensschritte 91, 93, 95, 97 können aber auch in einem gesonderten Computerprogrammprodukt implementiert sein und beispielsweise auch vom erfindungsgemässen Verfahren 199 gesondert ausgeführt werden.

Der dreidimensionale Digitaler-Doppelgänger-Datensatz 101 der Personentransportanlage 1 kann somit beispielsweise mittels des Computerprogrammproduktes 21 unter Berücksichtigung von zuvor erhobenen, kundenspezifischen Konfigurierungsdaten 81 aus Bauteilmodell-Datensätzen 107, 109, 111, 113, 115, 117, ... aufgebaut und in einem Speichermedium 29, beispielsweise auf der dargestellten Diskette oder in der Datenwolke 51 gespeichert werden.

Wie bereits zur Figur 1 erläutert, können die Bauteilmodell-Datensätze 107, 109, 111, 113, 115, ... unterschiedliche Konfigurationen aufweisen und sind durch charakterisierende Eigenschaften B, T, H, Mat, ... definiert, wobei jede charakterisierende Eigenschaft B, T, H, Mat, ... durch einen Vorgabe-Wert vordefiniert, durch einen Soll-Wert vorgegeben, oder durch einen Ist-Wert bestimmt ist.

Soll-Werte im Sinne der vorliegenden Erfindung sind Werte, die die charakterisierenden Eigenschaften B, T, H, Mat, ... eines Bauteilmodell-Datensatzes 107, 109, 111, 113, 115, ... in einer Soll-Konfiguration definieren. Solche Soll-Werte sind üblicherweise durch kundenspezifische Konfigurierungsdaten 81 bei einer ausgewählten Personentransportanlage 1 definiert oder können auf deren Basis errechnet werden.

Unter kundenspezifischen Konfigurierungsdaten 81 können dabei Vorgaben verstanden werden, welche Einzelfall-spezifisch vom Kunden zum Beispiel beim Ordern der Personentransportanlage 1 vorgegeben werden. Die kundenspezifischen Konfigurierungsdaten 81 beziehen sich dabei auf eine einzelne zu fertigende Personentransportanlage 1. Beispielsweise können die kundenspezifischen Konfigurierungsdaten 81 vorherrschende räumliche Bedingungen am Einbauort, Schnittstelleninformationen 129 zum Anbau an tragende Strukturen eines Bauwerks 131, etc. umfassen.

Anders ausgedrückt können die kundenspezifischen Konfigurierungsdaten 81 zum Beispiel angeben, wie viele Stockwerke die Personentransportanlage 1 verbinden soll, die Stockwerkhöhen Z, in welcher Weise die Personentransportanlage 1 an tragende Strukturen innerhalb des Gebäudes angebunden werden soll, und dergleichen mehr.

Kundenspezifische Konfigurierungsdaten 81 können auch Wünsche des Kunden hinsichtlich Funktionalität, Förderkapazität, Optik, etc. umfassen. Die Daten des dreidimensionalen Digitaler-Doppelgänger-Datensatzes 101 können beispielsweise als CAD-Datensatz vorliegen, welcher unter anderem als charakterisierende Eigenschaften B, T, H, ... geometrische Abmessungen und/oder andere charakterisierende Eigenschaften der die Personentransportanlage 1 bildenden Bauteile wiedergibt.

Das bedeutet, dass beispielsweise bei einem Abdeckungs-Bauteilmodell-Datensatz 111, dessen Vorgabe-Wert L als die Länge definierende, charakterisierende Eigenschaft, variabel ist, durch einen Soll-Wert ersetzt wird, der durch die kundenspezifischen Konfigurierungsdaten 81 vorgegeben wird. Gegebenenfalls ist der Soll-Wert auch noch mit einer Toleranzangabe versehen.

Ist-Werte im Sinne der vorliegenden Erfindung sind Werte, die am physischen Bauteil, welches durch den Bauteilmodell-Datensatz 107, 109, 111, 113, 115, ... virtuell abgebildet wird, durch Messen, Prüfen und Testen ermittelt wurden. Im Falle des vorher erwähntet Abdeckungs-Bauteilmodell-Datensatzes 111, würde dessen Vorgabe-Wert L als die Länge definierende, charakterisierende Eigenschaft, durch die am fertigen, nach diesem Abdeckungs-Bauteilmodell-Datensatz 111 gefertigten Werkstück gemessenen Länge L ersetzt.

Je mehr charakterisierende Eigenschaften B, T, H, L, ... eines Bauteilmodell-Datensatzes 107, 109, 111, 113, 115, ... durch einen Ist-Wert definiert sind, desto präziser ist insgesamt die Simulationsumgebung 33 und desto präziser sind die Simulationsergebnisse. Aus den vorgenannten Gründen können die Bauteilmodell-Datensätze 107, 109, 111, 113, 115, ... des als Simulationsumgebung 33 dienenden, dreidimensionalen Digitaler-Doppelgänger-Datensatzes 101 in gemischter Weise durch Vorgabe-Werte, Soll-Werte und Ist-Werte charakterisiert sein.

Die in der Figur 2 dargestellten Verfahrensschritte 91, 93, 95, 97 des Teil-Verfahrens 99 gliedern sich nach dem Start 89 dieser Verfahrensschritte 91, 93, 95, 97 zur Erstellung des dreidimensionalen Digitaler-Doppelgänger-Datensatzes 101 in einen ersten Verfahrensschritt 91 zur Erfassung von kundenspezifischen Konfigurierungsdaten 81, in einen zweiten Verfahrensschritt 93 zur Generierung eines, gegebenenfalls als Basiselement-Bauteilmodell-Datensatz 141 dienenden Fachwerk-Bauteilmodell-Datensatzes 115, in einen dritten Verfahrensschritt 95, in dem mit Hilfe des zuvor geschaffenen Basiselement-Bauteilmodell-Datensatzes 141 die weiteren Bauteilmodell-Datensätze 107, 109, 111, 113, 115, ... des dreidimensionalen Digitaler-Doppelgänger-Datensatzes 101 bestimmt und definiert werden und in einen vierten Verfahrensschritt 97, bei dem der dreidimensionalen Digitaler-Doppelgänger-Datensatz 101 aus den zuvor bestimmten und definierten Bauteilmodell-Datensätzen 107, 109, 111, 113, 115, ... anhand von Schnittstelleninformationen 119, 121 zusammengefügt wird. Sobald der dreidimensionale Digitaler-Doppelgänger-Datensatz 101 fertiggestellt und gespeichert worden ist, erreicht das Teil-Verfahren 99 das Ende 103 der den dreidimensionalen Digitaler-Doppelgänger-Datensatz 101 generierenden Verfahrensschritte 91, 93, 95, 97.

Im ersten Verfahrensschritt 91 werden kundenspezifische Konfigurierungsdaten 81 erfasst. Hierbei wird beispielsweise zwischen einer Arbeitsstation 123 und der programmierbaren Vorrichtung 19 (mit unterbrochener Linie symbolisch dargestellt; siehe auch Figur 1), auf der das Computerprogrammprodukt 21 zur Durchführung des Teil-Verfahrens 99 installiert ist, eine Verbindung 125 aufgebaut. Die programmierbare Vorrichtung 19 kann auch einen oder mehrere Computer umfassen. Insbesondere kann die programmierbare Vorrichtung 19 aus einem Computernetzwerk gebildet sein, welches Daten in Form einer Datenwolke 51 (Cloud) verarbeitet. Die programmierbare Vorrichtung 19 kann hierfür über einen nicht dargestellten Speicher verfügen, in dem die zur Erstellung des dreidimensionalen Digitaler-Doppelgänger-Datensatzes 101 erforderlichen Daten gespeichert werden können, beispielsweise in elektronischer oder magnetischer Form. Die programmierbare Vorrichtung 19 kann ferner über Datenverarbeitungsmöglichkeiten verfügen. Beispielweise kann die programmierbare Vorrichtung 19 einen nicht dargestellten Prozessor aufweisen, mithilfe dessen Daten des dreidimensionalen Digitaler-Doppelgänger-Datensatzes 101 verarbeitet werden können. Die programmierbare Vorrichtung 19 kann ferner über die mit einem Doppelpfeil symbolisch dargestellten Ein- und Ausgabe- Schnittstellen 133 verfügen, über die Daten in die programmierbare Vorrichtung 19 eingegeben und/oder aus der programmierbaren Vorrichtung 19 ausgegeben werden können. Die einzelnen Teile der programmierbaren Vorrichtung 19 sind variabel und der besseren Übersicht wegen mit Ausnahme der insbesondere als Speichermedium 29 dienenden Datenwolke 51, nicht detaillierter dargestellt.

Mittels verschiedener Abfragemasken 211 (Graphical User Interface) werden nach und nach die zur Erstellung eines des dreidimensionalen Digitaler-Doppelgänger-Datensatzes 101 erforderlichen, kundenspezifischen Konfigurierungsdaten 81 erfasst. Vorzugsweise werden die kundenspezifischen Konfigurierungsdaten 81 in einem Logfile 127 abgelegt und dieses Logfile 127 mit einer Identifizierungsnummer 135 oder mit einem Identifizierungscode versehen. Wie mittels eines Pfeils 137 angedeutet ist, wird das Logfile 127 in einem geeigneten Speichermedium 29 gespeichert. Im vorliegenden Ausführungsbeispiel ist das Speichermedium 29 die Datenwolke 51.

Das Logfile 127 ist vorzugsweise Teil des dreidimensionalen Digitaler-Doppelgänger-Datensatzes 101. Dies hat den besonderen Vorteil, dass der dreidimensionalen Digitaler-Doppelgänger-Datensatz 101 später anhand der kundenspezifischen Konfigurierungsdaten 81 identifiziert werden kann. Der Hersteller der Personentransportanlage 1 beziehungsweise dessen Datenverarbeitungssystem kann über den Identifizierungscode 135 auf die kundenspezifischen Konfigurierungsdaten 81 zugreifen und auf einfache Weise für Testzwecke einen oder mehrere geeignete dreidimensionale Digitaler-Doppelgänger-DatensätzelOl einer bereits bestehenden Personentransportanlage 1 suchen, auswählen und als Simulationsumgebung 33 einsetzen, so dass dieser nicht zuerst erstellt werden muss.

Wie bereits weiter oben erläutert, werden zur Erstellung eines dreidimensionalen Digitaler-Doppelgänger-Datensatzes 101 digitale Bauteilmodell- Datensätze 107, 113, 109, 111, 115, 117 verwendet, die eigentlich für die Fertigung der physischen Bauteile einer Personentransportanlage 1 vorgesehen sind. Hierbei ist zwischen definierten Bauteilmodell-Datensätzen 107, 113 und generischen Bauteilmodell-Datensätzen 109, 111, 115, 117 zu unterscheiden.

Definierte Bauteilmodell-Datensätze 107, 113 wie der in der Figur 2 dargestellte Bodenabdeckungs-Bauteilmodell-Datensatz 107, umfassen alle erforderlichen Daten, die zur Fertigung eines physischen Bauteiles erforderlich sind. Anders ausgedrückt geben die definierten Bauteilmodell-Datensätze 107 eine geplante Konfiguration einzelner Bauteile bezüglich aller für eine Fertigung der Personentransportanlage 1 wesentlichen charakterisierenden Eigenschaften wie die Breite B, Höhe H, Tiefe T, Materialangaben Mat und dergleichen mehr, wieder. Somit können definierte Bauteilmodell-Datensätze 107 als digitale Abbilder von physischen Bauteilen verstanden werden. Sie können beispielsweise als 3D-CAD-Datensatz vorliegen und zumindest die Geometrie, vorzugsweise aber auch weitere charakterisierende Eigenschaften, eines Bauteils derart ausreichend vollständig wiedergeben, dass darauf basierend das Bauteil mit für dessen Einsatz ausreichender Präzision gefertigt werden kann.

Ein definierter Bauteilmodell-Datensatz 107 kann beispielsweise als dreidimensionale Körperhülle des Bauteils angegeben sein. Dabei sind auch Toleranzangaben, Oberflächenangaben beispielsweise zur Farbe, Textur, Oberflächentraurigkeit, etc., Angaben zu Materialeigenschaften sowie Schnittstelleninformationen zu angrenzenden Bauteilen in den Daten des definierten Bauteilmodell-Datensatzes 107 enthalten. Definierte Bauteilmodell-Datensätze 107 werden daher für Bauteile bereitgestellt, welche standardisiert und/oder vielfach in verschiedenen Personentransportanlagen 1 zum Einsatz kommen. Beispielsweise werden beim Kommissionieren einer Aufzugsanlage, einer Fahrtreppe oder eines Fahrsteigs standardisierte definierte Bauteilmodell-Datensätze 107 von simplen Bauteilen wie zum Beispiel Schrauben, Kettenglieder einer Förderkette, der Bodenabdeckung etc. eingesetzt. Es können aber auch definierte Bauteilmodell-Datensätze 113 von komplexeren Bauteilen, die jedoch in einer gleichen Konfiguration oder einer Auswahl aus wenigen möglichen Konfigurationen für verschiedene Personentransportanlagen 1 verwendet werden, eingesetzt werden. Beispielsweise können definierte Bauteilmodell-Datensätze 113 von Trittstufen beziehungsweise Paletten, die in einer geringen Anzahl sich hinsichtlich ihrer Breite unterscheidender Varianten für Fahrtreppen beziehungsweise Fahrsteige unterschiedlicher Förderkapazität bereitgestellt werden, eingesetzt werden.

Die generischen Bauteilmodell-Datensätze 109, 111, 115, 117 sind Datensätze, die eine geplante Konfiguration mehrerer verschiedener Bauteile bezüglich mehrerer für eine Fertigung einer Personentransportanlage 1 wesentlichen charakterisierenden Eigenschaften so wiedergeben, dass ein generisches Bauteilmodell durch Berücksichtigen der zuvor erfassten kundenspezifischen Konfigurationsdaten 81 um Daten derart ergänzt werden kann, dass es ein einzelnes Bauteil bezüglich aller für eine Fertigung der Personentransportanlage 1 wesentlichen charakterisierenden Eigenschaften B, T, H, Mat, ... wiedergibt. Typische generische Bauteilmodell-Datensätze 109, 111, 115, 117 sind beispielsweise die in der Figur 2 dargestellten Balustraden- Bauteilmodell-Datensätze 109, 117, der Abdeckung-Bauteilmodell-Datensatz 111 oder der Fachwerk-Bauteilmodell-Datensatz 115.

Im Gegensatz zu definierten Bauteilmodell-Datensätzen 107, 113 geben generische Bauteilmodell-Datensätze 109, 111, 115, 117, die charakterisierenden Eigenschaften B, T, H, Mat, ... zunächst nicht so vollständig an, dass ein Bauteil lediglich basierend auf dem generischen Bauteilmodell-Datensatz 109, 111, 115, 117 bereits gefertigt werden könnte. Beispielsweise kann ein generischer Bauteilmodell-Datensatz 109, 111, 115, 117 zumindest hinsichtlich einer für die Fertigung wesentliche Eigenschaft unterbestimmt sein. Ein generischer Bauteilmodell-Datensatz 109, 111, 115, 117 kann somit gewissermassen als "unfertiges dreidimensionales Bauteilmodell" angesehen werden. Ein Vorteil hiervon ist, dass der generische Bauteilmodell-Datensatz 109, 111, 115, 117, aufgrund seiner Unterbestimmtheit hinsichtlich zumindest einer charakterisierenden Eigenschaft dazu eingesetzt werden kann, mehrere verschiedene Bauteile zu repräsentieren, wobei sich die verschiedenen Bauteile lediglich hinsichtlich der unterbestimmten charakterisierenden Eigenschaft B, T, H, Mat, ... voneinander unterscheiden. In den generischen Bauteilmodell-Datensätzen 109, 111, 115, 117 sind zwar auch Bauteildaten wie deren Abmessungen, Oberflächenstrukturen, andere charakterisierende Eigenschaften B, T, H, Mat, ..., generische und definierte Schnittstelleninformationen 119, 121 zu angrenzenden Bauteilmodell-Datensätzen und dergleichen mehr enthalten. Allerdings beschreibt ein generischer Bauteilmodell-Datensatz 109, 111, 115, 117 ein konkretes Bauteil noch nicht derart umfänglich, dass allein hiervon ausgehend das jeweilige Bauteil gefertigt und in der Personentransportanlage 1 montiert werden kann. Dementsprechend muss der generische Bauteilmodell-Datensatz 109, 111, 115, 117 unter Berücksichtigung der kundenspezifischen Konfigurierungsdaten 81 bezüglich der unterbestimmten Eigenschaft konkretisiert werden.

Somit kann mit allen, gemäss den kundenspezifischen Konfigurierungsdaten 81 ergänzten Bauteilmodell-Datensätzen 107, 109, 111, 113, 115, 117 und einer produktlinienspezifischen Erzeugungsroutine 139, welche einer Masterstückliste gleich, die Anzahl aller benötigten Bauteilmodell-Datensätze 107, 109, 111, 113, 115, 117 sowie deren Zusammenfügungsplan beinhaltet, ein dreidimensionaler Digitaler-Doppelgänger-Datensatz 101 der ausgewählten Personentransportanlage 1 zusammengesetzt werden.

Etwas detaillierter beschrieben, kann zum Beispiel wie in der Figur 2 dargestellt, die produktlinienspezifische Erzeugungsroutine 139 in die programmierbaren Vorrichtung 19 hochgeladen und ausgeführt werden. Hierdurch kann in einem zweiten Verfahrensschritt 93 aus der Datenwolke 51 ein generischer Bauteilmodell-Datensatz 115 abgerufen werden, der mittels den für diesen Bauteilmodell-Datensatz 115 relevanten, kundenspezifischen Konfigurierungsdaten 81 des Logfiles 127 in einen definierten Bauteilmodell- Datensatz überführt wird. In der Figur 2 ist dies der Fachwerk-Bauteilmodell-Datensatz 115 einer als Fahrtreppe ausgestalteten Personentransportanlage 1.

Beim genannten Beispiel kann dies bedeuten, dass während des Erstellens des dreidimensionalen Digitaler-Doppelgänger-Datensatzes 101 einer Fahrtreppe beziehungsweise eines Fahrsteigs die Bauteilmodell-Datensätze der Obergurte 143 und Untergurte 145 von deren Fachwerk- Bauteilmodell-Datensatz 115 definiert werden, indem diese hinsichtlich der zunächst nicht angegebenen Länge konkretisiert werden. Die Länge der Obergurte 143 und Untergurte 145 wird dabei aus den kundenspezifischen Konfigurationsdaten 81 hergeleitet, das heisst beispielsweise aus Abständen zwischen Auflagestellen 147, an denen gegenüberliegende Enden des Fachwerks in dem aufnehmenden Bauwerk 131 installiert werden sollen sowie gegebenenfalls aus einem Höhenunterschied Z zwischen diesen Auflagestellen 147.

Nachdem der generische Fachwerk-Bauteilmodell-Datensatz 115 in den definierten Zustand überführt worden ist, können durch die produktlinienspezifischen Erzeugungsroutine 139 veranlasst, im dritten Verfahrensschritt 95 auch die übrigen Bauteilmodell-Datensätze aus dem Speichermedium 51 abgerufen und gegebenenfalls definiert werden.

Wie weiter oben bereits erwähnt, sind die Bauteilmodell-Datensätze 107, 109, 111, 113, 115, 117 mit Schnittstelleninformationen 119, 121 zu angrenzenden Bauteilmodell-Datensätzen versehen, so dass nach dem Überführen aller generischen Bauteilmodell-Datensätze 109, 111, 115, 117 in definierte Bauteilmodell-Datensätze alle aufgrund der kundenspezifischen Konfigurierungsdaten 81 erforderlichen Bauteilmodell-Datensätze 107, 109, 111, 113, 115, 117 definiert und vorhanden sind. In einem vierten Verfahrensschritt 97 können nun diese Bauteilmodell-Datensätze 107, 109, 111, 113, 115, 117 mittels der produktlinienspezifischen Erzeugungsroutine 139 und den Schnittstelleninformationen 119, 121 zum dreidimensionalen Digitaler-Doppelgänger-Datensatz 101 vereinigt werden.

Um das Zusammenfügen zu beschleunigen, kann im vierten Verfahrensschritt 97 beispielsweise der definierte Fachwerk-Bauteilmodell-Datensatz 115, welcher die meisten Schnittstellen zu anderen Bauteilmodell-Datensätzen aufweist, durch die produktlinienspezifische Erzeugungsroutine 139 als Basisbauteilelement-Datensatz 141 definiert werden. Durch die Definierung eines Basisbauteilelement-Datensatzes 141 kann bildlich gesprochen im dreidimensionalen, virtuellen Raum ein Ausgangspunkt beziehungsweise eine Ausgangsbasis festgelegt werden. Diese kann zum raschen Aufbau des dreidimensionalen Digitaler-Doppelgänger-Datensatzes 101 herangezogen werden. Zwar weisen die zur Fertigung von physischen Bauteilen vorgesehenen, generischen und definierten Bauteilmodell-Datensätze 107, 109, 111, 113, 115, 117 ebenfalls Schnittstelleninformationen 119, 121 auf, diese sind aber nur auf die unmittelbar angrenzenden Bauteile beziehungsweise Bauteilmodell-Datensätze 107, 109, 111, 113, 115, 117 gerichtet. Mittels der produktlinienspezifischen Erzeugungsroutine 139 werden nun Schnittstelleninformationen generiert, die im dreidimensionalen Raum vom Basisbauteilelement-Datensatz 141 weiter entfernt angeordnete Bauteile beziehungsweise Bauteilmodell-Datensätze 107, 109, 111, 113, 117 betreffen. Hierdurch können schnellstmöglich alle Bauteilmodell-Datensätze 107, 109, 111, 113, 115, 117 an ihrer richtigen Position relativ zum Basisbauteilelement-Datensatz 141 angeordnet werden, um den dreidimensionalen Digitaler-Doppelgänger-Datensatz 101 zu bilden.

Der dreidimensionalen Digitaler-Doppelgänger-Datensatz 101 kann mit dem zugehörenden Logfile 127 verknüpft werden, indem in seinem Dateinamen nebst einer eigenen Kennzeichnung (beispielhaft als /DDD dargestellt) beispielsweise dieselbe Identifizierungsnummer 135 (beispielhaft als #1036 dargestellt) oder derselbe Identifizierungscode verwendet wird. Speicherort des dreidimensionalen Digitaler-Doppelgänger-Datensatzes 101 kann wie in der Figur 2 dargestellt, die Datenwolke 51 sein. Der dreidimensionale Digitaler-Doppelgänger-Datensatz 101 kann hernach aus der Datenwolke 51 ausgewählt und als Teil der Simulationsumgebung 33 dienend, in die programmierbare Vorrichtung 19 heruntergeladen werden. Nach dem vierten Verfahrensschritt 97 ist das Teilverfahrensende 103 erreicht.

Das beschriebene Teilverfahren 99 kann in einem eigenständigen Computerprogramm implementiert sein. Selbstverständlich kann dieses Computerprogramm auch Teil eines umfangreicheren Computerprogrammes, beispielsweise einer Betriebssoftware, einer Produktionsplanungssoftware und dergleichen mehr sein. Das Teilverfahren 99 sowie die vorangehend beschriebene produktlinienspezifische Erzeugungsroutine 139 und/oder ein Teil oder alle verfügbaren generischen und definierten Bauteilmodell-Datensätze 107, 109, 111, 113, 115, 117 können aber auch im Computerprogrammprodukt 21 implementiert sein.

Das Computerprogrammprodukt 21 kann auf einem computerlesbaren Speichermedium 29 abgespeichert sein. Das computerlesbare Speichermedium 29, in der Figur 2 symbolisch als Diskette abgebildet, kann ein beliebiges Speichermedium 29 wie beispielsweise eine Festplatte, ein Speicherchip, ein flüchtiger oder nichtflüchtiger Arbeitsspeicher oder natürlich auch die Datenwolke 51 sein. Das Computerprogrammprodukt 21 umfasst maschinenlesbare Programmanweisungen, welche bei Ausführung auf der programmierbaren Vorrichtung 19 diese zum Durchführen oder Steuern eines Verfahrens 199 und gegebenenfalls des Tei-Verfahrens 99 veranlassen. Hierbei kann die programmierbare Vorrichtung 19 ein Computer, ein Tablet, ein Computernetzwerk, eine Arbeitsstation 123 aber auch die Datenwolke 51 sein.

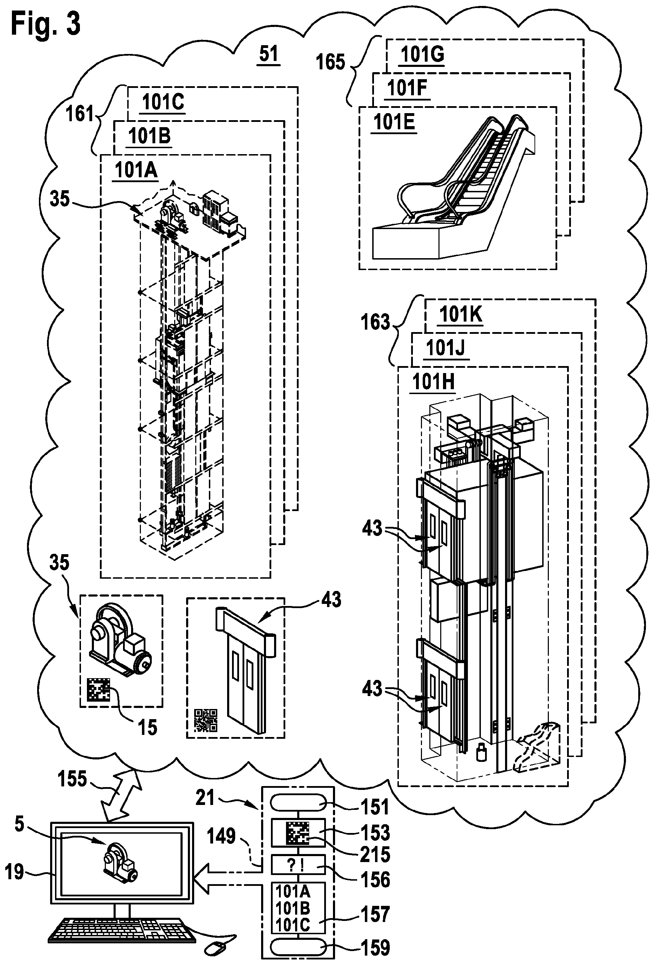

In der Figur 3 ist schematisch ein weiterer Teilaspekt der vorliegenden Erfindung beziehungsweise des Verfahrens 199 dargestellt. Dieser Teilaspekt betrifft die wichtigsten Interaktionen einer Suchroutine 149 zur Identifizierung von bereits vorhandenen und damit auswählbaren dreidimensionalen Digitaler-Doppelgänger-Datensätzen 101A bis 101K die geeignet sind, als Simulationsumgebung 33 für die zu testende physische Komponente 5 zu dienen. Um diese dreidimensionalen Digitaler-Doppelgänger-Datensätze 101A bis 101K, welche bestehende Personentransportanlagen 1 abbilden, voneinander und vor einem zu erstellenden Digitaler-Doppelgänger-Datensatz 101 zu unterscheiden, sind deren Bezugszeichen in der Figur 3 um einen Buchstaben ergänzt worden. Alle dreidimensionalen Digitaler-Doppelgänger-Datensätze 101A bis 101K sind beispielsweise in der Datenwolke 51 abgespeichert. Die dreidimensionalen Digitaler-Doppelgänger-Datensätze 101A bis 101K können hierbei in Produktelinien 161, 163, 165 gruppiert sein.

Wie dargestellt, wird die mittels strichdoppelpunktierter Umrandung markierte, als weitere Teilprogrammschritte im Computerprogrammprodukt 21 implementierte Suchroutine 149 in der programmierbaren Vorrichtung 19 durchgeführt. Nach dem Suchroutinen-Start 151 werden in einem ersten Suchschritt 153 charakterisierende Eigenschaften und/oder Kennzeichen 215 (hier ein auf der zu testenden Komponente 5 aufgeklebter Matrix-Code) der zu testenden, physischen Komponente 5 in die programmierbare Vorrichtung 19 eingegeben. Die Suchroutine 149 baut nun zur Datenwolke 51 eine Verbindung 155 mittels der in der Suchroutine 149 hinterlegten richtigen Speicheradresse auf, und sucht über einen Vergleichsalgorithmus 156 nach korrespondierenden Bauteilmodell-Datensätzen 35, 43 mit diesen Kennzeichen 215 oder mit entsprechenden charakterisierenden Eigenschaften.

Sofern wie im vorliegenden Beispiel der Bauteilmodell-Datensatz 35 der zu testenden Komponente 5 gefunden wird, können in einem dritten Suchschritt 157 vorhandene, dreidimensionale Digitaler-Doppelgänger-Datensätze 101A bis 101K nach diesem Bauteilmodell-Datensatz 35 durchsucht werden. Da die zu testende physische Komponente 5 in einer Produktelinie 161 verwendet wird, sind mehrere dreidimensionale Digitaler-Doppelgänger-Datensätze 101A bis 101C vorhanden, die diesen Bauteilmodell-Datensatz 35 aufweisen. Deshalb werden alle diese dreidimensionalen Digitaler-Doppelgänger-Datensätze 101A bis 101 als mögliche Simulationsumgebung 33 zur Auswahl vorgeschlagen, wobei die wichtigsten Leistungsmerkmale der abgebildeten Personentransportanlagen 1 wie beispielsweise die Förderhöhe und dergleichen mehr, als Auswahlhilfe mit angezeigt werden. Aus diesen Vorschlägen kann nun der Versuchsingenieur den gewünschten dreidimensionalen Digitaler-Doppelgänger-Datensatz 101 auswählen und als Simulationsumgebung 33 in die programmierbare Vorrichtung 19 hochladen. Mit dem Akzeptieren eines dieser Vorschläge oder Ablehnen aller Vorschläge ist das Suchroutinen-Ende 159 erreicht.

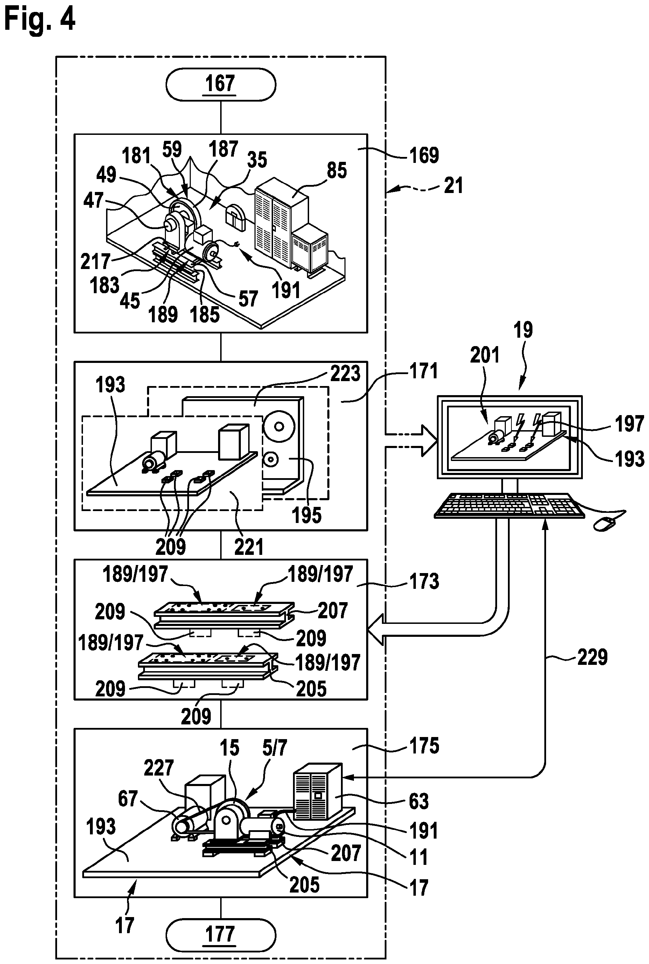

Die Figur 4 zeig schematisch verschiedene Teil-Verfahrensschritte 169, 171, 173, 175 zur Bereitstellung einer geeigneten physischen Schnittstelle 17, damit die zu testende physische Komponente 5 mit der Simulationsumgebung 33 (siehe Figur 1) verbunden werden kann. Wie dargestellt, können die mittels strichdoppelpunktierter Umrandung markierten Teil-Verfahrensschritte 169, 171, 173, 175 ebenfalls im Computerprogrammprodukt 21 implementiert sein und in der programmierbaren Vorrichtung 19 ausgeführt werden.

Nach dem Teilverfahrensstart 167 können in einem ersten Teilverfahrensschritt 169 Schnittstelleninformationen 181, 183, 189, 191 derjenigen Bauteilmodell-Datensätze 85, 187, 185 ausgelesen werden, die dem Bauteilmodell-Datensatz 35 angrenzend angeordnet sind und dessen zugeordnete physische Komponente 5, hier die Antriebseinheit 7, getestet werden soll. Anhand dieser ausgelesenen Schnittstelleninformationen 181, 183, 189, 191 kann die physische Schnittstelle 17 zur Wirkverbindung der programmierbaren Vorrichtung 19 mit der zu testenden physischen Komponente 5 bereitgestellt und konfiguriert werden.

Im vorliegenden Ausführungsbeispiel sind die angrenzenden Komponenten der zu testenden Antriebseinheit 5/7 der Steuerungs- Bauteilmodell-Datensatz 85, ein Antriebsrahmen-Bauteilmodell-Datensatz 185 und ein Tragmittel-Bauteilmodell-Datensatz 187.

Die zugeordnete Schnittstelleninformation 191 des Steuerungs-Bauteilmodell-Datensatzes 85 umfasst die Ansteuerungsdaten des Antriebsmotor-Bauteilmodell-Datensatzes 45 sowie Ausgestaltung der elektrischen Verbindung zwischen diesen Bauteilmodell-Datensätzen 45, 85. Des Weiteren weist der Antriebsmotor-Bauteilmodell-Datensatz 45 Schnittstellen 57 zum Antriebsrahmen-Bauteilmodell-Datensatz 185 auf, dessen Schnittstelleninformationen 189 die Lochdurchmesser und das Lochbild definieren. Dasselbe gilt für die Schnittstelle 217 mit den Schnittstelleninformationen 183, die zwischen dem Getriebe-Bauteilmodell-Datensatz 47 und dem Antriebsrahmen-Bauteilmodell-Datensatz 185 angeordnet ist. Die Schnittstelleninformation 181 der Schnittstelle 59 zwischen dem Tragmittel-Bauteilmodell-Datensatz 187 und dem Treibscheiben-Bauteilmodell-Datensatz 49 weist Angaben zu den Abmessungen der Traktionsfläche wie die Tragmittelbreite und den Umschlingungswinkel, Angaben zur Anpresskraft des Tragmittels an der Treibscheibe sowie zum Reibungskoeffizient zwischen Tragmittel und Treibscheibe auf, und insbesondere, dass an dieser Schnittstelle 59 dynamische, mechanische Vorgänge stattfinden. Gegebenenfalls sind noch weitere Angaben wie die Steifigkeit des Tragmittels und dergleichen mehr in der Schnittstelleninformation 181 enthalten.

In einem zweiten Teilverfahrensschritt 171 gilt es nun, anhand der ausgelesenen Schnittstelleninformationen 181, 183, 189, 191 aus verfügbaren physischen Schnittstellen 193, 195 diejenige auszuwählen, welche die meisten der ausgelesenen Schnittstelleninformationen 181, 183, 189, 191 verwirklicht. Dies kann vorzugsweise automatisiert anhand eines Vergleichs der Schnittstelleninformationen 181, 183, 189, 191 mit den Angaben zu den verfügbaren physischen Schnittstellen 193, 195 erfolgen, sofern diese ebenfalls als Bauteilmodell-Datensätze 221, 223 beispielsweise aus der Datenwolke 51 abrufbar sind. Anschliessend wird entweder eine verfügbare physische Schnittstelle 193 ausgewählt oder es wird eine Meldung angezeigt, dass keine der verfügbaren, physischen Schnittstellen 193, 195 ein Minimum an Schnittstellenübereinstimmungen aufweist und die physische Schnittstelle 17 von Grund auf erstellt werden muss. Sofern eine verfügbare physische Schnittstelle 193 ausgewählt worden ist, kann zum Schluss dieses zweiten Teilverfahrensschrittes 171 diese ausgewählte physische Schnittstelle 193 auf fehlende Schnittstellenübereinstimmungen überprüft, und die symbolisch mit Blitzen dargestellten, differierenden Schnittstelleninformationen 197 über eine Ausgabeschnittstelle 201 ausgeben werden.

In einem dritten Teilverfahrensschritt 173 können aus den differierenden Schnittstelleninformationen 197 Adaptermittel 205, 207 erzeugt werden. Diese Adaptermittel 205, 207 können sowohl mechanische Schnittstellen wie Verbindungsflansche, Kopplungselemente, Stecker und dergleichen mehr sein. Die Adaptermittel 205, 207 können aber auch Programmteile wie Compiler, Transferprotokolle und dergleichen mehr sein. Bei mechanischen Schnittstellen wie Befestigungsstellen kann beispielsweise als Grundlage der Bauteilmodell-Datensatz 221 der ausgewählten physische Schnittstelle 193 verwendet werden. Zu diesem werden nun die differierenden Schnittstelleninformationen 197/183, 197/189 räumlich angeordnet. Anschliessend können die Adaptermittel 205, 207 im Raum zwischen den vorhandenen Schnittstellen 209 der ausgewählten physischen Schnittstelle 193 und der differierenden Schnittstelleninformationen 197 /183, 197/189 als fabrikationsbereite Bauteilmodell-Datensätze generiert werden. Hierzu sind beispielsweise bekannte Computerprogramme verfügbar, mit denen die Adaptermittel 205, 207 durch den Ansatz funktionsgetriebenen Designs automatisch generiert werden können.

Mit anderen Worten können die Bauteilmodell-Datensätze von Adapterbauteilen 205, 207 dadurch individuell aufgrund ihrer Funktion, ihren Einbaubedingungen sowie auf diese einwirkenden Kräfte und Belastungen für physische Schnittstelle 17 Topologie- optimiert konfiguriert und in weiterer Folge auch produziert werden. Aus dem Anpassen vorhandener physischer Schnittstellen 193, 195 ergeben sich beträchtliche Vorteile für den Ressourcenverbrauch, da nur die unbedingt notwendige Menge an Material verbraucht wird (z.B. Stahl, Aluminium) sowie neuartige, ressourcensparende Produktionstechniken einsetzbar sind, wodurch Rohmaterial und Kosten gespart werden können.

Da der Erfolg solcher Tests auch immer eine zeitkritische Komponente beinhaltet, kann mindestens ein Bauteilmodell-Datensatz eines Adapterbauteils 205, 207 mit entsprechenden produktionsspezifischen Daten versehen, an eine 3D-Druckmaschine übertragen und mittels dieses Bauteilmodell-Datensatzes ein physisches Adapterbauteil 205, 207 erzeugt werden. Hierdurch können diese sehr speziellen Einzelstücke ressourcenschonend produziert werden und sind gewissermassen «über Nacht» verfügbar.

In einem vierten Teilverfahrensschritt 175 wird nun mit diesen Adaptermitteln 205, 207 die ausgewählte physische Schnittstelle 193 zur einsatzbereiten, physischen Schnittstelle 17 ergänzt. Hernach kann wie bereits zur Figur 1 beschrieben, die zu testende Komponente 5 mit der physischen Schnittstelle 17 verbunden werden. Hierbei wird die zu testende physische Komponente 5 auf den Adaptermitteln 205, 207 festgeschraubt, der Antriebsmotor 11 über die Schnittstelle 191 mit der Aufzugssteuerung 63 wirkverbunden und die Treibscheibe 15 und der Generator 67 mittels eines Riemens 227 mechanisch gekoppelt. Wie der Doppelpfeil 229 andeutet, muss auch eine Kommunikationsverbindung zwischen der Aufzugssteuerung 63 und der programmierbaren Vorrichtung 19 eingerichtet werden. Danach ist die die zu testende physische Komponente 5 über die physische Schnittstelle 17 mit der programmierbaren Einrichtung 19 verbunden und kann in der Simulationsumgebung 33 getestet werden.

Obwohl die vorliegende Erfindung in den Figuren 1 bis 4 am Beispiel einfacher dreidimensionaler Digitaler-Doppelgänger-Datensätze 101, welche nur beispielhaft mit wenigen Bauteilmodel-Datensätzen aufgebaut sind, beschrieben wurde, ist es offensichtlich, dass das beschriebene Verfahren 199 gleichermassen auch mit komplexer aufgebauten, dreidimensionalen Digitaler-Doppelgänger-Datensätzen 101 Anwendung findet. Auch wenn beispielsweise nur eine Aufzugskabine 37 beschrieben und in den Figuren dargestellt ist, kann das erfindungsgemässe Verfahren 199 selbstverständlich auch bei Aufzugsanlagen mit mehreren Aufzugskabinen 37 verwendet werden. Ferner müssen nicht alle Verfahrensschritte in einem einzigen Computerprogrammprodukt 21 implementiert sein sondern können auch auf mehrere Computerprogrammprodukte 21 verteilt sein.

Abschliessend ist darauf hinzuweisen, dass Begriffe wie "aufweisend", "umfassend", etc. keine anderen Elemente oder Schritte ausschliessen und Begriffe wie "eine" oder "ein" keine Vielzahl ausschliessen. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren (199) zum Testen physischer Komponenten (5) einer Personentransportanlage (1), wobei die zu testende, physische Komponente (5) über eine physische Schnittstelle (17) mit einer programmierbaren Vorrichtung (19) wirkverbunden werden kann, **dadurch gekennzeichnet, dass** auf die programmierbare Vorrichtung (19) ein dreidimensionaler Digitaler-Doppelgänger-Datensatz (101) als Simulationsumgebung (33) geladen wird, der eine ausgewählte Personentransportanlage (1) abbildet und simuliert;
• wobei der dreidimensionale Digitaler-Doppelgänger-Datensatz (101) analog zu der, durch ihn wiedergegebenen physischen Personentransportanlage (1) aus Bauteilmodell-Datensätzen (35, 39, 43, 45, 47, 49) aufgebaut ist;
• wobei jeder dieser Bauteilmodell-Datensätze (35, 39, 43, 45, 47, 49) jeweils ein physisches Bauteil (11, 13, 15, 37, 41) der Personentransportanlage (1) durch charakterisierende Eigenschaften (B, T, H, Mat) abbildet, welche zumindest eine strukturelle, eine physikalische und/oder eine zeitgebundene Eigenschaft des abgebildeten physischen Bauteils (11, 13, 15, 37, 41) wiedergeben;
• wobei jeder dieser Bauteilmodell-Datensätze (35, 39, 43, 45, 47, 49) Schnittstelleninformationen (x, y, z, F, M, f, 119, 120, 181, 183, 189, 191) zu angrenzenden Bauteilmodell-Datensätzen (35, 39, 43, 45, 47, 49) aufweist, welche die Zusammenwirkung der miteinander verbundenen Bauteile an der jeweiligen Schnittstelle (55, 57, 59) enthält; und
• wobei anstelle eines dieser Bauteilmodell-Datensätze (35, 39, 43, 45, 47, 49) die zu testende physische Komponente (5) über die physische Schnittstelle (17) in die Simulationsumgebung (33) wirkverbunden wird und mittels einer Testroutine (31) die physische Komponente (5) in der Simulationsumgebung (33) unter Einbindung der Schnittstelleninformationen (x, y, z, F, M, f, 119, 120, 181, 183, 189, 191) getestet wird.

2. Verfahren (199) nach Anspruch 1, wobei der Bauteilmodell-Datensatz (35) der zu testenden, physischen Komponente (5) aktualisiert wird, indem durch das Testen ermittelte Ergebnisse als zusätzliche charakterisierende Eigenschaften (B, T, H, Mat) diesem Bauteilmodell-Datensatz (35) zugeordnet und/oder vorhandene charakterisierende Eigenschaften (B, T, H, Mat) und/oder Schnittstelleninformationen (x, y, z, F, M, f, 119, 120, 181, 183, 189, 191) aktualisiert werden.

3. Verfahren (199) nach Anspruch 2, wobei die physische Schnittstelle (17) von der programmierbaren Vorrichtung (19) entfernt wird und das Verhalten des, mit dem aktualisierten Bauteilmodell-Datensatz (35) ergänzten, dreidimensionalen Digitaler-Doppelgänger-Datensatzes (101) mittels der Testroutine (31) verifiziert wird.

4. Verfahren (199) nach einem der Ansprüche 1 bis 3, wobei Parameter der Testroutine (31) und die Testroutine (31) als charakterisierende Eigenschaften (B, T, H, Mat) in einem Steuerungs-Bauteilmodell-Datensatz (85) des dreidimensionalen Digitaler-Doppelgänger-Datensatzes (101) gespeichert werden.

5. Verfahren (199) nach einem der Ansprüche 1 bis 4, wobei die Testroutine (31) unter Verwendung von Daten einer Daten-Historie (87) eines dreidimensionalen Digitaler-Doppelgänger-Datensatzes (101) generiert wird, wobei in dieser Daten-Historie (87) Testroutinen (31) und zugehörende Parameter (83) abgespeichert sind, welche mit diesem dreidimensionalen Digitaler-Doppelgänger-Datensatz (101) bereits durchgeführt wurden.

6. Verfahren (199) nach einem der Ansprüche 1 bis 5, wobei die getestete physische Komponente (5) anhand der durch das Testen ermittelten Ergebnisse optimiert wird.

7. Verfahren (199) nach einem der Ansprüche 1 bis 6, wobei mittels einer Suchroutine (149) anhand von charakterisierenden Eigenschaften (B, T, H, Mat) und/oder Kennzeichen (215) der zu testenden, physischen Komponente (5) in einem Speichermedium (29) ein korrespondierender Bauteilmodell-Datensatz (35) gesucht wird und sofern ein solcher gefunden wird, vorhandene, dreidimensionale Digitaler Doppelgänger-Datensätze (101) nach diesem Bauteilmodell-Datensatz (35) durchsucht werden, wobei die diesen Bauteilmodell-Datensatz (35) aufweisenden, dreidimensionalen Digitaler-Doppelgänger-Datensätze (101) als Simulationsumgebung (33) zur Auswahl vorgeschlagen werden.

8. Verfahren (199) nach einem der Ansprüche 1 bis 6, wobei der dreidimensionale Digitaler-Doppelgänger-Datensatz (101) der Personentransportanlage (1) mittels eines Computerprogrammproduktes (21) unter Berücksichtigung von zuvor erhobenen, kundenspezifischen Konfigurierungsdaten (81) aus Bauteilmodell-Datensätzen (35, 39, 43, 45, 47, 49) aufgebaut und in einem Speichermedium (29) gespeichert wird, wobei die Bauteilmodell-Datensätze (35, 39, 43, 45, 47, 49) unterschiedliche Konfigurationen aufweisen können und durch charakterisierende Eigenschaften (B, T, H, Mat) definiert sind, wobei jede charakterisierende Eigenschaft (B, T, H, Mat) durch einen Vorgabe-Wert vordefiniert, durch einen Soll-Wert vorgegeben, oder durch einen Ist-Wert bestimmt ist.

9. Verfahren (199) nach einem der Ansprüche 1 bis 8, wobei vor dem Testen der physischen Komponente (5) Schnittstelleninformationen (x, y, z, F, M, f, 119, 120, 181, 183, 189, 191) derjenigen Bauteilmodell-Datensätze (35, 39, 43, 45, 47, 49) ausgelesen werden, die dem Bauteilmodell-Datensatz (35) angrenzend angeordnet sind, dessen zugeordnete physische Komponente (5) getestet werden soll und anhand dieser ausgelesenen Schnittstelleninformationen (x, y, z, F, M, f, 119, 120, 181, 183, 189, 191) die physische Schnittstelle (17) zur Wirkverbindung der programmierbaren Vorrichtung (19) mit der zu testenden physischen Komponente (5) bereitgestellt und konfiguriert wird.

10. Verfahren (199) nach Anspruch 9, wobei anhand der ausgelesenen Schnittstelleninformationen (x, y, z, F, M, f, 119, 120, 181, 183, 189, 191) aus verfügbaren physischen Schnittstellen (193, 195) diejenige ausgewählt wird, welche die meisten der ausgelesenen Schnittstelleninformationen (x, y, z, F, M, f, 119, 120, 181, 183, 189, 191) verwirklicht.

11. Verfahren (199) nach Anspruch 10, wobei die ausgewählte physische Schnittstelle (193) auf fehlende Schnittstellenübereinstimmungen überprüft, und die differierenden Schnittstelleninformationen (197) über eine Ausgabeschnittstelle (201) ausgeben werden.

12. Verfahren (199) nach Anspruch 11, wobei aus den differierenden Schnittstelleninformationen (197) Adaptermittel (205, 207) erzeugt, und mit diesen die physische Schnittstelle (17) einsatzbereit gemacht wird.

13. Verfahren (199) nach einem der Ansprüche 9 bis 12, wobei aus den ausgelesenen Schnittstelleninformationen (x, y, z, F, M, f, 119, 120, 181, 183, 189, 191) dynamische charakterisierende Eigenschaften identifiziert und diese an Aktuatoren (105) der physischen Schnittstelle (17) übertragen werden.

14. Computerprogrammprodukt (21), umfassend maschinenlesbare Programmanweisungen, welche bei Ausführung auf einer programmierbaren Vorrichtung (19) die programmierbare Vorrichtung (19) zum Durchführen oder Steuern eines Verfahrens (199) gemäss einem der Ansprüche 1 bis 13 veranlassen.

15. Computerlesbares Speichermedium (29, 51) mit einem darauf gespeicherten Computerprogrammprodukt (21) gemäss Anspruch 14.
